(19) Europäisches Patentamt
European Patent Office
Office européen des brevets

(11) EP 2 196 503 B1

(12) **EUROPEAN PATENT SPECIFICATION**

(45) Date of publication and mention of the grant of the patent:
**18.02.2015 Bulletin 2015/08**

(21) Application number: **09178580.8**

(22) Date of filing: **10.12.2009**

(51) Int Cl.:
***C08L 83/04*** *(2006.01)* ***C09D 183/04*** *(2006.01)*
***G02B 1/04*** *(2006.01)* ***G02B 3/00*** *(2006.01)*
***H01L 23/29*** *(2006.01)* ***H01L 33/56*** *(2010.01)*
***C08L 83/05*** *(2006.01)* ***C08L 83/07*** *(2006.01)*

(54) **Thermosetting silicone resin composition, silicone resin, silicone resin sheet and use thereof**

Wärmehärtende Silikonharzzusammensetzung, Silikonharz, Silikonharzfolie und Verwendung dafür

Composition de résine de silicone thermodurcissable, résine de silicone, feuille de résine de silicone et leur utilisation

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority:
**12.12.2008 JP 2008317149**
**12.12.2008 JP 2008317150**
**02.02.2009 JP 2009021520**
**14.04.2009 JP 2009098136**
**11.05.2009 JP 2009114787**

(43) Date of publication of application:
**16.06.2010 Bulletin 2010/24**

(73) Proprietor: **Nitto Denko Corporation**
**Ibaraki-shi**
**Osaka 567-8680 (JP)**

(72) Inventors:
- **Katayama, Hiroyuki**
**Ibaraki-shi Osaka (JP)**
- **Fujioka, Kazuya**
**Ibaraki-shi Osaka (JP)**

(74) Representative: **Grünecker, Kinkeldey, Stockmair & Schwanhäusser**
**Leopoldstrasse 4**
**80802 München (DE)**

(56) References cited:
**EP-A1- 0 664 328**
**EP-A2- 0 273 706**
**EP-A2- 0 841 385**
**US-A- 4 558 109**
**US-A- 5 804 631**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 196 503 B1

## Description

The present invention relates to a thermosetting silicone resin composition, a silicone resin, a silicone resin sheet obtained from the thermosetting silicone resin composition or the silicone resin, and a use thereof. More particularly, the invention relates to a thermosetting silicone resin composition which can form a semi-cured state where encapsulation processing of an optical semiconductor element can be performed, and has excellent light resistance and heat resistance; a silicone resin; a method for producing the silicone resin; a silicone resin sheet obtained from the composition; a resin cured material obtained by curing the sheet; a microlens array; an optical semiconductor element encapsulation material containing the sheet; and an optical semiconductor device encapsulated with the encapsulation material.

High-power white LED devices whose application to generic illumination has been studied demand encapsulation materials having light resistance and heat resistance, In recent years, thermoplastic silicone resins have been studied, and so-called "addition curing type silicone" has been heavily used.

This addition curing type silicone is obtained by thermal curing of a mixture mainly composed of a silicone derivative having vinyl groups on a main chain and a silicone derivative having SiH groups on a main chain thereof in the presence of a platinum catalyst. For example, JP-A-2000-198930 discloses a resin composition which provides a cured material having excellent transparency and insulating characteristics by introducing an organopolysiloxane into a composition to set the molar ratio of silicon-bonded hydrogen atoms in the composition to alkenyl groups to a specific range.

JP-A-2004-186168 discloses a resin composition containing a silicone resin having at least two silicon-bonded Alkenyl groups in one molecule and an organohydrogensilane and/or an organohydrogenpolysiloxane having at least two silicon-bonded hydrogen atoms in one molecule.

JP-A-2008-150437 discloses a composition which provides a cured material having an excellent strength by using a straight-chain polyorganohydrogensiloxane having a silicon-bonded hydrogen atom (a Si-H group) midway of a molecular chain in combination with a straight-chain polyorganohydrogensiloxane having a silicon-bonded hydrogen atoms (Si-H groups) at both ends of a molecular chain in specific amounts.

On the other hand, a high active platinum catalyst is generally used in the addition curing type silicone resin. Accordingly, when a curing reaction once starts, it is extremely difficult to stop the reaction halfway. It is therefore difficult to form a semi-cured state (stage B). Then, it has been known that addition of phosphorus compound, nitrogen compound, a sulfur compound or an acetylene as a reaction inhibitor is effective, in order to decrease the catalytic activity of the platinum catalyst (for example, see JP-A-6-118254).

EP-A-0273706 discloses a curable, self-adhering polyorganosiloxane composition comprising the product obtained by blending to homogeneity

A. a first organosiloxane material which is curable by a platinum-catalyzed hydrosilylation reaction and comprises 1) a liquid polydiorganosiloxane containing two vinyl radicals per molecule, 2) an organohydrogensiloxane containing at least three silicon-bonded hydrogen atoms per molecule; and 3) a platinum containing catalyst;
B. from 0 to 60% by weight, based on the weight of the first organosiloxane composition, of a benzene-soluble copolymer consisting essentially of diorganovinylsiloxy units, triorganosiloxy units and $SiO_{4/2}$ units;
C. from 0.1 to 20% by weight of a moisture curable organosiloxane material that is compatible with the first organosiloxane material and comprises a mixture of a liquid hydroxyl terminated polydiorganosiloxane and a crosslinking agent consisting essentially of a silane; and a catalyst selected from the group consisting of titanium orthoesters and chelated titanium compounds.

US-A-4558109 discloses an organopolysiloxane composition having an improved adhesion and being curable at an elevated temperature in the presence of atmospheric moisture comprising:

(a) an organopolysiloxane having an average of at least two hydroxyl groups per molecule;
(b) an organosilicon compound containing aliphatic unsaturation and having an average of at least two hydrolyzable groups per molecule, said hydrolyzable groups are linked to a silicon atom of the organosilicon compound and are selected from the group consisting of acyloxy groups, aminoxy groups, amine groups, acylamine groups, oxime groups, mixtures and partial hydrolyzates thereof having 2 to 10 silicon atoms per molecule;
(c) an organohydrogenpolysiloxane having an average of at least one silicon-bonded hydrogen atom per molecule;
(d) a platinum catalyst; and
(e) from 0 to 8% by weight based on the weight of the organopolysiloxane of a polycondensation catalyst.

EP-A-0664328 discloses a pressure-sensitive adhesive composition comprising:

(A) 20 to 90 parts of a benzene-soluble, capped, organopolysiloxane resin;

(B) 10 to 80 parts of an alkenyl functional polydiorganosiloxane polymer;
(C) an organohydrogenpolysiloxane compound having an average of at least 3 silicon-bonded hydrogen atoms per molecule;
(D) 0.5 to 10 parts per 100 parts of (A) and (B) of an alkenetrialkoxysilane;
(E) a platinum containing catalyst; and
(F) 0.5 to 10 parts per 100 parts of (A) and (B) of a moisture curing catalyst to promote the moisture-initiated reaction of the alkoxy radicals of (D).

EP-A-0841385 discloses a silicone adhesive composition comprising a mixture of:

(A) 40 to 95 parts of an alkenyl functional siloxane resin;
(B) 0. 5 to 20 parts of a SiH containing polyorganosiloxane;
(C) a silane comprising alkyl radicals having from 1 to 6 carbon atoms and/or aryl radicals having from 1 to 6 carbon atoms and/or aryl radicals having 6 to 10 carbon atoms;
(D) a hydrosilylation catalyst in sufficient quantity to promote curing of said composition; and
(E) a moisture curing catalyst.

However, although the conventional addition curing type silicone resins have excellent durability, they are composed of viscous liquid before the curing reaction, so that handling becomes complicated, and the viscosity varies depending on the surrounding environment in some cases. Thus, they remain unsatisfactory.

Further, the silicone resins are poor in heat resistance because they decompose accompanied by the occurrence of cyclic oligosiloxane under conditions of 200°C or higher, which causes a problem that the periphery of a semiconductor device encapsulated with the silicone resin is contaminated, or that the light-emitting luminance deceases with time.

Furthermore, compounds known as a reaction inhibitor exert an influence on durability of the resins, so that another method of reaction control is required.

An object of the invention is to provide a thermosetting silicone resin composition which has excellent optical transparency, light resistance, heat resistance and adhesiveness, and can form a semi-cured state where encapsulation processing of an optical semiconductor element can be performed and excellent handling properties are shown, a silicone resin sheet, a method for producing the silicone resin sheet, a resin cured material obtained by curing the sheet, a microlens array, an optical semiconductor element encapsulation material containing the sheet, an optical semiconductor device encapsulated with the encapsulation material.

Namely, the invention relates to the following items .

(1) A thermosetting silicone resin composition comprising a condensation reatable substituent group-containing silicon compound and an addition reactable substituent group-containing silicon compound, wherein said composition comprises:

(1) a dual-end silanol type silicone oil as the condensation reactable substituent group-containing silicon compound;
(2) an alkenyl group-containing silicon compound;
(3) an organohydrogensiloxane as the addition reactable substituent group-containing silicon compound;
(4) tetramethylammonium hydroxide as a condensation catalyst; and
(5) a hydrosilylation catalyst.

(2) A silicone resin obtained by a condensation reaction of the above thermosetting silicone resin composition .
(3) A silicone resin sheet obtained by forming the above silicone resin into a sheet in a semi-cured state.
(4) A method for producing a silicone resin in a semi-cured state, said method including a step of heating the above thermosetting silicone resin composition including a condensation reactable substituent group-containing silicon compound and an addition reactable substituent group-containing silicon compound at 40 to 120°C.
(5) A silicone resin cured material obtained by completely curing the above silicone resin sheet.
(6) An optical semiconductor element encapsulation material including above the silicone resin sheet.
(7) An optical semiconductor device obtained by encapsulating an optical semiconductor element by using the above optical semiconductor element encapsulation material.
(8) A microlens array obtained by molding the above silicone resin.

Preferred embodiments are set forth in the subclaims.

The thermosetting silicone resin composition of the invention exhibits excellent effects of being able to provide a silicone resin having excellent optical transparency, light resistance, heat resistance and adhesiveness and being able

to form a semi-cured state where encapsulation processing of an optical semiconductor element can be performed.

The silicone resin of the invention is obtained by a condensation reaction of a thermosetting silicone resin composition containing a condensation reactable substituent group-containing silicon compound and an addition reactable substituent group-containing silicon compound. Additionally, it is possible to obtain a silicone resin in a semi-cured state.

A semi-cured state (hereinafter also referred to as stage B) of a general epoxy resin or the like is usually achieved by controlling thermosetting conditions. Specifically, for example, a crosslinking reaction of a monomer is allowed to partially proceed by heating at 80°C, thereby preparing pellets of stage B. Then, the resulting pellets are subjected to desired molding processing, and then, heated at 150°C to be completely cured.

On the other hand, the addition curing type silicone resin is obtained by an addition reaction (hydrosilylation reaction) of a silicone derivative having vinyl groups on a main chain thereof and a silicone derivative having SiH groups on a main chain thereof, and a high active platinum catalyst is generally used. Accordingly, when a curing reaction once starts, it is extremely difficult to stop the reaction halfway. It is therefore difficult to form stage B, It is also known to control the reaction with a reaction inhibitor. However, a progress of the reaction varies depending on the kind and amount of reaction inhibitor used, so that the control with the reaction inhibitor is not easy.

In the invention, curing (first-step curing) from stage A (uncured state) to stage B (semi-cured state) and curing (second-step curing) from stage B (semi-cured state) to stage C (completely cured state) are performed by different reactions, that is to say, the first-step curing is performed by the condensation reaction, and the second-step curing is performed by the addition reaction (hydrosilylation reaction), thereby controlling the reaction utilizing the difference in reaction temperature conditions between both reactions. Thus, each curing is gradually allowed to proceed, thereby being able to obtain a resin sheet in the semi-cured state in which the first-step curing has been terminated. Further, the second-step curing reaction proceeds by external factors, not by natural factors, so that it becomes possible to maintain a state at the time when the first-step curing has been terminated, that is to say, the semi-cured state, Furthermore, it becomes possible to control physical properties such as viscoelasticity, toughness and tackiness of a semi-cured material and a completely cured material by controlling the density of functional groups relating to each reaction. Incidentally, in this specification, the semi-cured material, that is to say, the material in the semi-cured state (stage B), means a material in a state between stage A where the material is soluble in a solvent and stage B where the material is completely cured, and in a state where curing or gelation somewhat proceeds, and the material is swelled but is not completely dissolved in a solvent, and is softened but not melted by heating. The completely cured material means a material in a state where curing or gelation has completely proceeded.

The silicone resin sheet of the invention is obtained by forming the silicone resin obtained by the condensation reaction of the thermosetting silicone resin composition containing the condensation reactable substituent group-containing silicon compound and the addition reactable substituent group-containing silicon compound as described above into a sheet in the semi-cured state.

There is no particular limitation on the condensation-reactable substituent group-containing silicon compound (hereinafter also referred to as the condensation reaction monomer), as long as it has such constituent groups.

As the condensation-reactable substituent groups, there are exemplified, for example, a hydroxyl group, an amino group, an alkoxy group, a carboxyl group, an ester group, a halogen atom and the like, and preferred examples thereof include a hydroxyl group and an alkoxy group. There is no particular limitation on the number of the substituent groups contained in one molecule thereof.

Such a compound is preferably, for example, a dual-end silanol type silicone oil represented by formula (I):

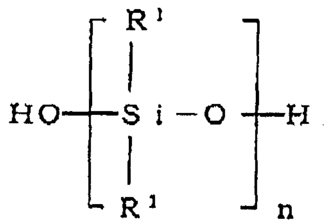

(I)

in which $R^1$ represents a monovalent hydrocarbon group having 1 to 20 carbon atoms or a hydrogen atom, and n is an integer of 1 or more, provided that all $R^1$ groups may be the same or different.

$R^1$ in formula (I) represents a monovalent hydrocarbon group having 1 to 20 carbon atoms, preferably 1 to 10 carbon atoms, or a hydrogen atom, from the viewpoints of ease of preparation and thermal stability. The hydrocarbon groups include saturated or unsaturated, straight-chain, branched or cyclic hydrocarbon groups. Specifically, there are exemplified a methyl group, an ethyl group, a propyl group, a butyl group, a pentyl group, a hexyl group, a phenyl group,

a naphthyl group, a cyclohexyl group, a cyclopentyl group. Above all, a methyl group is preferred from the viewpoints of transparency and light resistance. Incidentally, in formula (I), all $R^1$ groups may be the same or different. However, it is preferred that all are methyl groups.

Although n in formula (I) represents an integer of 1 or more, it is preferably an integer of 1 to 10,000, and more preferably an integer of 1 to 2,000, from the viewpoints of stability and handling properties.

Examples of such compounds represented by formula (I) include a dual-end silanol type polydimethylsiloxane, a dual-end silanol type polymethylphenylsiloxane and a dual-end silanol type polydiphenylsiloxane. These can be used either alone or as a combination of two or more thereof. Of these, preferred is a compound in which all $R^1$ groups are methyl groups and n is an integer of 1 to 1,000.

From the viewpoints of stability and handling properties, the number average molecular weight (hereinafter referred to the molecular weight) is preferably from 100 to 1,000,000, and more preferably from 100 to 100,000. Incidentally, in this specification, the molecular weight of the silicone derivative is measured by gel filtration chromatography (GPC).

The content of the compound represented by formula (I) in the condensation reaction monomer is preferably 50% by weight or more, more preferably 80% by weight or more and still more preferably substantially 100% by weight.

The content of the condensation reaction monomer is preferably from 1 to 99% by weight, more preferably from 50 to 99% by weight and still more preferably from 80 to 99% by weight, in the composition.

There is no particular limitation on the addition-reactable substituent group-containing silicon compound (hereinafter also referred to as the addition reaction monomer), as long as it has such constituent groups.

As the addition-reactable substituent groups, there are exemplified, for example, an alkenyl group, a hydrogen atom, an alkynyl group, a carbonyl group, a thiol group, an epoxy group, an amino group, a hydroxyl group, a sulfide group. Preferred examples thereof include a hydrogen atom and an alkenyl group. There is no particular limitation on the number of the substituent groups contained in one molecule thereof.

Such a compound is preferably, for example, at least one organohydrogensiloxane selected from the group consisting of a compound represented by formula (III):

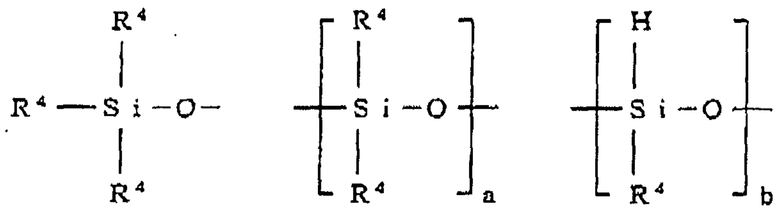

(III)

A B C

in which A, B and C are constituent units, A represents an end unit, B and C each represents a repeating unit, $R^4$ represents a monovalent hydrocarbon group having 1 to 20 carbon atoms, a represents an integer of 0 or 1 or more, and b represents an integer of 2 or more, provided that all $R^4$ groups may be the same or different, and a compound represented by formula (IV):

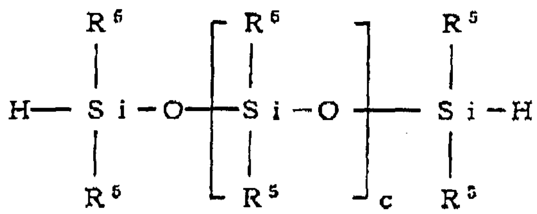

(IV)

in which $R^5$ represents a monovalent hydrocarbon group, and c represents an integer of 0 or 1 or more, provided with all $R^5$ groups may be the same or different.

The compound represented by formula (III) is a compound constituted by the constituent units A, B and C, in which A is the end unit, B and C are the repeating units, and hydrogen atoms are contained in the repeating units.

$R^4$ groups in formula (III), that is to say, all of $R^4$ in the constituent unit A, $R^4$ in the constituent unit B and $R^4$ in the constituent unit C, represent a monovalent hydrocarbon group, and include saturated or unsaturated, straight-chain, branched or cyclic hydrocarbon groups. The carbon number of the hydrocarbon group is from 1 to 20, and preferably from 1 to 10, from the viewpoints of ease of preparation and thermal stability. Specifically, there are exemplified a methyl group, an ethyl group, a propyl group, a butyl group, a pentyl group, a hexyl group, a phenyl group, a naphthyl group, a cyclohexyl group, a cyclopentyl group. Above all, a methyl group and an ethyl group are preferred from the viewpoints of transparency and light resistance. Incidentally, in formula (III), all $R^4$ groups may be the same or different, and each independently represents the above-mentioned hydrocarbon group regardless of the constituent unit.

The constituent group A is the end group, and two units are contained in formula (III).

The repeating unit number of the constituent unit B, that is to say, a in formula (III), represents an integer of 0 or 1 or more, From me viewpoint of reactivity, it is preferably an integer of 2 to 10,000, and more preferably an integer of 2 to 1,000.

As for the repeating unit number of each constituent unit described above, the sum of a and b is preferably from 2 to 10,000, and more preferably from 2 to 2,000. Further, the ratio of a to b (a/b) is preferably from 1,000/1 to 1/1,000, and more preferably from 100/1 to 1/100.

Examples of such compounds represented by formula (III) include a methylhydrogenpolysiloxane, a dimethylpolysiloxane-CO-methylhydrogenpolysiloxane, an ethylhydrogenpolysiloxane and a methylhydrogenpolysiloxane-CO-methylphenylpolysiloxane. These can be used either alone or as a combination of two or more thereof. Of theses, preferred are a compound in which $R^4$ is a methyl group, a is 0, and b is an integer of 2 or more, and a compound in which $R^4$ is an ethyl group, a is 0, and b is an integer of 2 or more.

The molecular weight of the compound represented by formula (III) is preferably from 100 to 1,000,000, and more preferably from 100 to 100,000, from the viewpoints of stability and handling properties.

The compound represented by formula (IV) is a compound having hydrogen atoms at both ends.

$R^5$ in formula (IV) represents a monovalent hydrocarbon group, and examples thereof include saturated or unsaturated, straight-chain, branched or cyclic hydrocarbon groups. The carbon number of the hydrocarbon group is from 1 to 20, and preferably from I to 10, from the viewpoints of ease of preparation and thermal stability. Specifically, there are exemplified a methyl group, an ethyl group, a propyl group, a butyl group, a pentyl group, a hexyl group, a phenyl group, a naphthyl group, a cyclohexyl group, a cyclopentyl group. Above all, a methyl group and an ethyl group are preferred from the viewpoints of transparency and light resistance. Incidentally, in formula (IV), all $R^5$ groups may be the same or different. However, it is preferred that all are methyl groups or ethyl group.

Although c in formula (IV) represents an integer of 0 or 1 or more, it is preferably an integer of 1 to 10,000, and more preferably an integer of I to 2,000, from the viewpoint of reactivity.

Examples of such compounds represented by formula (IV) include a dual-end hydrosilyl type polydimethylsiloxane, a dual-end hydrosilyl type polymethylphenylsiloxane and a dual-end hydrosilyl type polydiphenylsiloxane. These can be used either alone or as a combination of two or more thereof. Of these, preferred are a compound in which all $R^5$ groups are methyl groups and c is an integer of 1 to 1,000, and a compound in which all $R^5$ groups are ethyl groups and c is an integer of 1 to 1,000.

The molecular weight of the compound represented by formula (V) is preferably from 100 to 1,000,000, and more preferably from 100 to 100,000, from the viewpoints of stability and handling properties.

The total content of the compounds represented by formula (III) and formula (IV) in the addition reaction monomer is preferably 50% by weight or more, more preferably 80% by weight or more and still more preferably substantially 100% by weight

The content of the addition reaction monomer is preferably from 0.1 to 99% by weight, more preferably from 0.1 to 90% by weight and still more preferably from 0.1 to 80% by weight, in the composition.

The weight ratio of the condensation reaction monomer to the addition reaction monomer (condensation reaction monomer/addition reaction monomer) is preferably from 99.9/0.1 to 1/99.9, more preferably from 99.9/0.1 to 50/50, and still more preferably 99.9/0.1 to 90/10, from the viewpoint of viscoelasticity at the time of sheet formation.

The silicone resin composition in the invention contains a condensation catalyst and a hydrosilylation catalyst, in addition to the above-mentioned monomers.

The condensation catalyst is tetramethylammonium hydroxide from the viewpoints of compatibility and thermal degradability.

The content of the condensation catalyst in the composition is preferably from 0.1 to 50 moles, and more preferably from 1.0 to 5 moles, based on 100 moles of the condensation reaction monomer.

The hydrosilylation catalyst catalyzes a hydrosilylation reaction of a hydrosilane compound and an alkene. As specific compounds, there are exemplified platinum catalysts such as platinum black, platinum chloride, chloroplatinic acid, a platinum-olefin complex, a platinum-carbonyl complex and platinum-acetyl acetate; palladium catalysts; rhodium catalysts. Above all, a platinum-carbonyl complex is preferred from the viewpoints of compatibility, transparency and catalytic activity.

The content of the hydrosilylation catalyst in the composition is preferably from $1.0 \times 10^{-4}$ to 0.5 part by weight, and more preferably from $1.0 \times 10^{-3}$ to 0.05 part by weight, based on 100 parts by weight of the addition reaction monomer.

Further, the silicone resin of the invention is obtained by reacting the composition containing the above-mentioned condensation reaction monomer and addition reaction monomer under conditions the condensation reaction, so that it has such a structure that the condensation reaction monomer forms a crosslinked structure,
in which the addition reaction monomer is dispersed. In the invention, from the viewpoint of strength of the cured material obtained by performing the curing reaction, it is preferred that the silicone resin composition in the invention further contains a compound reactable with both of the condensation reaction monomer and the addition reaction monomer (hereinafter also referred to as a condensation/addition monomer), in addition to the above compounds. The use of such a composition results in obtaining a cured material having such a structure that not only the respective monomer molecules of the condensation reaction monomer and the addition reaction monomer are crosslinked with one another, but also the condensation reaction monomer is crosslinked with the addition reaction monomer, when the curing reaction is entirely conducted.

The condensation/addition monomer has a functional group reactable with the condensation reaction monomer and a functional group reactable with the addition reaction monomer, in one molecule thereof.

The functional groups reactable with the condensation reaction monomer include substituent groups similar to the above-mentioned condensation reactable substituent groups, and there is no particular limitation on the number of the substituent groups in one molecule thereof,

The functional groups reactable with the addition reaction monomer include substituent groups similar to the above-mentioned addition reactable substituent groups, and there is no particular limitation on the number of the substituent groups in one molecule thereof.

As such a compound, an alkenyl group-containing silicon compound may be mentioned. Specifically, for example, a compound represented by formula (II):

$$R^2\text{-}Si(X^1)_3 \qquad (II)$$

in which $R^2$ represents a substituted or unsubstituted, straight-chain or branched alkenyl group having 2 to 20 carbon atoms, and $X^1$ represents a halogen atom, an alkoxy group, a phenoxy group or an acetoxy group, provided that three $X^1$ groups may be the same or different, is preferred.
Additionally, an alkenyl group-containing trialkoxysilane represented by formula (II'):

$$R^2\text{-}Si(OR^3)_3 \qquad (II')$$

in which $R^2$ represents a substituted or unsubstituted, straight-chain or branched alkenyl group having 2 to 20 carbon atoms, and $R^3$ represents a monovalent hydrocarbon group, provided that three $R^3$ groups may be the same or different, is particularly preferred. In the alkenyl group-containing trialkoxysilane, the alkenyl group addition reacts with the addition reaction monomer, and the alkoxy group condensation reacts with the condensation reaction monomer.

$R^2$ in formulas (II) and (II') represents a substituted or unsubstituted, straight-chain or branched alkenyl group, and is an organic group containing an alkenyl group in a skeleton thereof. The carbon number of the organic group is preferably from 1 to 20, and more preferably from 1 to 10, from the viewpoints of ease of preparation and thermal stability, Specifically, there are exemplified a vinyl group, an allyl group, a propenyl group, a butenyl group, a pentenyl group, a hexenyl group, a heptenyl group, an octenyl group, a norbornenyl group, a cyclohexenyl group . Above all, a vinyl group is preferred from the viewpoint of reactivity to the hydrosilylation reaction.

$X^1$ in formula (II) represents a halogen atom, an alkoxy group, a phenoxy group or an acetoxy group. The halogen atom is preferably a chlorine atom, a bromine atom or an iodine atom, and more preferably a chlorine atom, from the viewpoint of reactivity, The carbon number of the alkoxy group is preferably from 1 to 10, and more preferably from 1 to 6, from the viewpoints of availability and economic efficiency. Specifically, there are exemplified a methoxy group, an ethoxy group, a propoxy group, a butoxy group, a pentoxy group, a hexyloxy group, a cyclohexyloxy group. Above all, a methoxy group is preferred from the view point of reactivity to the condensation reaction. Incidentally, in formula (II), all $X^1$ groups may be the same or different. However, it is preferred that all are methoxy groups.

Examples of such compounds represented by formula (II) include vinyltrichlorosilane, vinyltribromosilane, vinyltriiodosilane, vinyltrimethoxysilane, vinyltriethoxysilane, allyltrimethoxysilane, propenyltrimethoxysilane, norbornenyltrimethoxysilane and octenyltrimethaxysilane. These can be used either alone or as a combination of two or more thereof. Of these, preferred is vinyltrimethoxysilane in which $R^2$ is a vinyl group and all $X^1$ groups are methoxy groups.

$R^3$ in formula (II') is a monovalent hydrocarbon group, that is to say, an alkyl group, and $OR^3$ represents an alkoxy group. The carbon number of the hydrocarbon group is preferably from 1 to 10, and more preferably from 1 to 6, from the viewpoint of reactivity. Specifically, there are exemplified a methyl group, an ethyl group, a propyl group, a butyl group, a pentyl group, a hexyl group. Above all, a methyl group is preferred from the view point of reactivity to the condensation reaction. Incidentally, in formula (II'), all $R^3$ groups may be the same or different. However, it is preferred that all are methyl groups.

Examples of such compounds represented by formula (II') include vinyltrimethoxysilane, vinyltriethoxysilane, allyltrimethoxysilane, propenyltrimethoxysilane, norbornenyltrimethoxysilane and octenyltrimethoxysilane. These can be used either alone or as a combination of two or more thereof. Of these, preferred is vinyltrimethoxysilane in which $R^2$ is a vinyl group and all $R^3$ groups are methyl groups.

The content of the compound represented by formula (II) or formula (II') in the condensation/addition monomer is preferably 50% by weight or more, more preferably 80% by weight or more and still more preferably substantially 100% by weight.

The content of the condensation/addition monomer is preferably from 0.01 to 90% by weight, more preferably from 0.01 to 50% by weight, and still more preferably from 0,01 to 10% by weight, in the composition.

The content of the alkenyl group-containing silicon compound represented by formula (II) is preferably from 0.01 to 10 parts by weight, and more preferably from 0.1 to 5 parts by weight, based on 100 parts by weight of the dual-end silanol type silicone resin, from the viewpoint of strength of the resulting cured material.

Further, when the dual-end silanol type silicone oil represented by formula (I) is used as the condensation reaction monomer and the alkenyl group-containing trialkoxysilane represented by formula (II') is used as the condensation/addition monomer, the weight ratio of both is as follows. That is to say, from the viewpoint of allowing SiOH groups of the dual-end silanol type silicone oil and $SiOR^3$ groups of the alkenyl group-containing trialkoxysilane to react with each other in just proportion, the molar ratio ($SiOH/SiOR^3$) of the above-mentioned functional groups is preferably from 20/1 to 0.2/1, more preferably from 10/1 to 0.5/1, and still more preferably substantially equivalent (1/1). When the above-mentioned molar ratio is 20/1 or less, the silicone resin sheet of the invention has moderate toughness, whereas when it is 0.2/1 or more, the alkenyl group-containing trialkoxysilane does not become too much, resulting in good heat resistance of the resulting resin.

Furthermore, when the organohydrogensiloxane represented by formula (III) or formula (IV) is used as the addition reaction monomer in the above, the weight ratio of the alkenyl group-containing trialkoxysilane and the organohydrogenpolysiloxane is as follows. That is to say, from the viewpoint of allowing $SiR^2$ groups of the alkenyl group-containing trialkoxysilane and SiH groups of the organohydrogensiloxane to react with each other in just proportion, the molar ratio ($SiR^2/SiH$) of the above-mentioned functional groups is preferably from 20/1 to 0.1/1, more preferably from 10/1 to 0,2/1, still more preferably from 10/1 to 0.5/1, and yet still more preferably substantially equivalent (1/1). When the above-mentioned molar ratio is 20/1 or less, the silicone resin sheet of the invention has moderate toughness, whereas when it is 0.1/1 or more, the organohydrogensiloxane does not become too much, resulting in good heat resistance and toughness of the resulting resin.

Incidentally, the silicone resin composition in the invention may contain additives such as an antioxidant, a modifying agent, a surfactant, a dye, a pigment, a discoloration preventing agent and an ultraviolet absorber, in addition to the above, within the range not impairing the effects of the invention.

The silicone resin composition in the invention can be prepared without any particular limitation, as long as the composition contains the condensation reactable substituent group-containing silicon compound and the addition reactable substituent group-containing silicon compound. However, from the viewpoint of appropriately selecting the reaction temperature and time depending on respective reaction mechanisms of the condensation reaction and the addition reaction to allow the reaction to proceed and to be completed, the composition may be prepared by previously mixing components relating to the condensation reaction, and then, mixing components relating to the addition reaction.

The mixing of the components relating to the condensation reaction can be performed by stirring the additives such as the condensation catalyst, the condensation/addition monomer and optionally an organic solvent with the condensation reaction monomer, preferably at 0 to 60°C for 5 minutes to 24 hours. Incidentally, the condensation/addition monomer is a component relating to both the condensation reaction and the addition reaction. However, it is preferred that the condensation/addition monomer is mixed concurrently with the condensation reaction monomer, because the condensation reaction is started at a lower temperature than the addition reaction.

There is no particular limitation on the organic solvent. However, 2-propanol is preferred from the viewpoint of enhancing compatibility of the silicone derivative and the condensation catalyst.

The existing amount of the organic solvent is preferably from 3 to 20 parts by weight, and more preferably from 5 to 10 parts by weight, based on 100 parts by weight of the total amount of the condensation reaction monomer and the condensation/addition monomer. When the existing amount is 3 parts by weight or more, the reaction proceeds satisfactorily, whereas when it is 20 parts by weight or less, foaming of the composition in the curing step is reduced.

Incidentally, the condensation reaction of the condensation reaction monomer and the condensation/addition monomer may be partially initiated. The progress degree of the condensation reaction can be confirmed, for example, when the alkenyl group-containing silicon compound is used as the condensation/addition monomer, by the degree of disappearance of a peak derived from the $SiX^1$ group of the alkenyl group-containing silicon compound or the degree of disappearance of a peak derived from the SiOH group of the dual-end silanol type silicone oil, and when the alkenyl group-containing trialkoxysilane is used, by the degree of disappearance of a peak derived from the alkoxy group in its molecule according to $^1H$-NMR. measurement.

Then, in addition to the addition reaction monomer, the addition reaction catalyst is added as the component relating to the addition reaction to the mixture of the above-mentioned components relating to the condensation reaction. The composition in the invention provides the cured material by conducting two kinds of reactions, the condensation reaction and the addition reaction. The sheet in the semi-cured state is prepared by conducting only the condensation reaction. Accordingly, there is no particular limitation on the mixing method, as long as the components relating to the addition reaction are uniformly mixed with the mixture of the above-mentioned components relating to the condensation reaction.

Thus, the silicone resin composition can be prepared. In the invention, from me viewpoints of elastic modulus and storage stability, the composition contains:

(1) the dual-end silanol type silicone oil,
(2) the alkenyl group-containing trialkoxysilane,
(3) the organohydrogensiloxane
(4) tetramethylammonium hydroxide as the condensation catalyst, and
(5) the hydrosilylation catalyst.

The above-mentioned components of (1) to (5) will be specifically described below.

(1) Dual-end Silanol Type Silicone Oil

There is no particular limitation on the dual-end silanol type silicone oil in the invention. However, from the viewpoint of compatibility with each component, the compound represented by the above-mentioned formula (I) is preferred. Incidentally, in the invention, the end silanol groups of the dual-end silanol type silicone oil bring about the condensation reaction, so that the dual-end silanol type silicone oil is referred to as the condensation reaction monomer.

The content of the compound represented by formula (I) in the dual-end silanol type silicone oil is preferably 50% by weight or more, more preferably 80% by weight or more, and still more preferably substantially 100% by weight.

The content of the dual-end silanol type silicone oil is preferably from 1 to 99% by weight, more preferably from 50 to 99% by weight, and still more preferably from 80 to 99% by weight, in the composition.

(2) Alkenyl Group-Containing Trialkoxysilane

There is no particular limitation on the alkenyl group-containing silicon compound in the invention. However, from the viewpoint of compatibility with each component, the alkenyl group-containing trialkoxysilane represented by the above-mentioned formula (II') is preferred. In the invention, the alkenyl group of the alkenyl group-containing trialkoxysilane brings about the hydrosilylation reaction, and the alkoxy group thereof brings about the condensation reaction to resinify the composition. Accordingly, the alkenyl group-containing trialkoxysilane is a compound which reacts with both of the component relating to the condensation reaction and the component relating to the hydrosilylation reaction. When the composition of the invention is cured, the monomer relating to the condensation reaction and the monomer relating to the hydrosilylation reaction are bonded to each other through the alkenyl group-containing trialkoxysilane.

The content of the alkenyl group-containing trialkoxysilane represented by formula (II') in the alkenyl group-containing silicon compound is preferably 50% by weight or more, more preferably 80% by weight or more, and still more preferably substantially 100% by weight.

The content of the alkenyl group-containing trialkoxysilane is preferably from 0.01 to 90% by weight, more preferably from 0.01 to 50% by weight, and still more preferably from 0.01 to 10% by weight, in the composition.

Further, the weight ratio of the dual-end silanol type silicone oil and the alkenyl group-containing trialkoxysilane is as follows, That is to say, from the viewpoint of allowing SiOH groups of dual-end silanol type silicone oil and $SiOR^3$ groups of the alkenyl group-containing trialkoxysilane to react with each other in just proportion, the molar ratio ($SiOH/SiOR^3$) of the above-mentioned functional groups is preferably from 20/1 to 0.2/1, more preferably from 10/1 to 0.5/1, and still more preferably substantially equivalent (1/1). When the above-mentioned molar ratio is 20/1 or less, a semi-cured material having moderate toughness is obtained in the case where the composition of the invention is semi-cured, whereas when it is 0.2/1 or more, the alkenyl group-containing trialkoxysilane does not become too much, resulting in good heat resistance of the resulting resin.

(3) Organohydrogensiloxane

There is no particular limitation on the organohydrogensiloxane in the invention. However, from the viewpoint of compatibility with each components, at least one selected from the group consisting of the compound represented

by the above-mentioned formula (III) and the compound represented by formula (IV) is preferred. In the invention, the SiH groups of the organohydrogensiloxane bring about the hydrosilylation reaction, so that the organohydrogensiloxane is referred to as a monomer relating to the hydrosilylation reaction. Incidentally, in this specification, the Organohydrogensiloxane means a generic term of all compounds including from low-molecular weight compounds to high-molecular weight compounds such as the organohydrogensiloxane and the organohydrogenpolysiloxane.

The total content of the compounds represented by the above-mentioned formula (III) and formula (IV) in the organohydrogensiloxane is preferably 50% by weight or more, more preferably 80% by weight or more, and still more preferably substantially 100% by weight.

The content of the organohydrogensiloxane is preferably from 0.1 to 99% by weight, more preferably from 0.1 to 90% by weight, and still more preferably from 0.1 to 80% by weight, in the composition.

Further, the weight ratio of the alkenyl group-containing trialkoxysilane and the organohydrogensiloxane is as follows. That is to say, from the viewpoint of allowing $SiR^2$ groups of the alkenyl group-containing trialkoxysilane and SiH groups of the organohydrogensiloxane to react with each other in just proportion, the molar ratio ($SiR^2$/SiH) of the above-mentioned functional groups is preferably from 20/1 to 0.05/1, more preferably from 20/1 to 0.1/1, still more preferably from 10/1 to 0.2/1, and yet still more preferably from 5/1 to 0.2/1. When the above-mentioned molar ratio is 20/1 or less, the semi-cured material having moderate toughness is obtained in the case where the composition of the invention is semi-cured, whereas when it is 0.05/1 or more, the organohydrogensiloxane does not become too much, resulting in good heat resistance and toughness of the resulting resin. Further, the composition in which the above-mentioned molar ratio is from 0.05/1 to less than 1/1 is faster in the curing rate from the composition to the semi-cured state than the composition in which the above-mentioned molar ratio is from 1/1 to 20/1, and can be cured for a shorter period of time.

The weight ratio of the monomer relating to the condensation reaction and the monomer relating to the hydrosilylation reaction, that is to say, the weight ratio of the dual-end silanol type silicone oil and the organohydrogensiloxane (dual-end silanol type silicone oil/organohydrogensiloxane) is preferably from 99.9/0.1 to 1/99, more preferably from 99.9/0.1 to 50/50, and still more preferably from 99.9/0.1 to 90/10, from the viewpoint of viscoelasticity at the time of sheet formation.

(4) Condensation Catalyst

The condensation catalyst is tetramethylammonium hydroxide from the viewpoints of compatibility and thermal degradability. Although tetramethylammonium hydroxide in a solid state may be used as it is, it is preferably used as an aqueous solution or a methanol solution from the viewpoint of handling properties. It is more preferably used as a methanol solution from the viewpoint of transparency of the resin. Tetramethylammonium hydroxide decomposes to methanol and trimethylamine at 150°C or higher to vaporize, so that it also achieves an effect that it does not remain as impurities in the resin after curing. The content of tetramethylammonium hydroxide in such a condensation catalyst is preferably 20% by weight or more, more preferably 50% by weight or more, and still more preferably substantially 100% by weight.

The content of the condensation catalyst in the composition is preferably from 0,1 to 50 moles, and more preferably from 1.0 to 5 moles, based on 100 moles of the dual-end silanol type silicone oil.

(5) Hydrosilylation Catalyst

There is no particular limitation on the hydrosilylation catalyst in the invention, as long as it is a compound which catalyzes the hydrosilylation reaction of the hydrosilane compound and the alkene. There are exemplified platinum catalysts such as platinum black, platinum chloride, chloroplatinic acid, a platinum-olefin complex, a platinum-carbonyl complex and platinum-acetyl acetate; palladium catalysts, rhodium catalysts. Above all, a platinum-carbonyl complex is preferred from the viewpoints of compatibility, transparency and catalytic activity.

Further, as the hydrosilylation catalyst having high reactivity, it is also preferred to contain a platinum-1,3-divinyl-1,1,3,3-tetramethyldisiloxane complex, and the content thereof in the hydrosilylation catalyst is preferably 20% by weight or more, more preferably 50% by weight or more, and still more preferably substantially 100% by weight.

For example, when the platinum catalyst is used, the content of the hydrosilylation catalyst in the thermosetting silicone resin composition according to the invention is preferably from $1.0\times10^{-4}$ to 1 part by weight, more preferably from $1.0\times10^{-4}$ to 0.5 part by weight, and still more preferably from $1.0\times10^{-3}$ to 0.05 part by weight, based on 100 parts by weight of the organohydrogensiloxane, in terms of the amount of platinum.

It is preferred that the thermosetting silicone resin composition in the invention contains an epoxy group-containing silicon compound together with the alkenyl group-containing silicon compound represented by the above-mentioned formula (II) or the alkenyl group-containing trialkoxysilane represented by formula (II'), Adhesiveness and toughness of the composition and the cured material can be improved by allowing the epoxy group-containing silicon

compound to be contained.

There is no particular limitation on such an epoxy group-containing silicon compound, as long as it contains an epoxy group. The epoxy group may be directly bonded to silicon, or an organic group partially containing the epoxy group may be bonded to silicon. Further, when the epoxy group-containing silicon compound contains a functional group relating to the condensation reaction as a substituent group other than the above, the compound is bonded to the monomer relating to the condensation reaction. As a result, it is considered that the epoxy groups are present in the cured material in a well-dispersed state to improve adhesiveness. Incidentally, in this specification, the epoxy group and the organic group partially containing the epoxy group are referred to as an "epoxy structure-containing substituent group".

From the viewpoint as describe above, the epoxy group-containing silicon compound in the invention is preferably a compound having an epoxy group and functional groups to the condensation reaction, which is represented by formula (V):

$$R^6\text{-}Si(X^2)_3 \qquad (V)$$

wherein $R^6$ represents an epoxy structure-containing substituent group, and $X^2$ represents a halogen atom, an alkoxy group, a phenoxy group or an acetoxy group, provided that three $X^2$ groups may be the same or different.

$R^6$ in formula (V) represents an epoxy structure-containing substituent group, and is an organic group containing an epoxy group in a skeleton thereof. Specifically, there are exemplified a 3-glycidoxypropyl group, an epoxycyclohexylethyl group, a glycidyl group, an epoxycyclohexyl group, an epoxycyclopentyl group. Above all, a 3-glycidoxypropyl group and an epoxycyclohexylethyl group are preferred from the viewpoints of reactivity and handling properties,

$X^2$ in formula (V) represents a halogen atom, an alkoxy group, a phenoxy group or an acetoxy group, and these are all a functional group relating to the condensation reaction. The halogen atom is preferably a chlorine atom, a bromine atom or an iodine atom, and more preferably a chlorine atom, from the viewpoint of reactivity. The alkoxy group is preferably a methoxy group, an ethoxy group, a propoxy group, a butoxy group or a cyclohexyloxy group, and more preferably a methoxy group, from the viewpoints of reactivity and handling properties. Incidentally, in formula (V), three $X^2$ groups may be the same or different. However, it is preferred that all are methoxy groups.

Examples of such compounds represented by formula (V) include the following compounds:

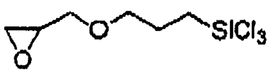 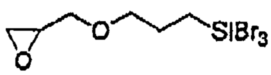 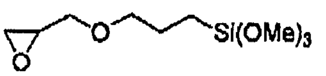

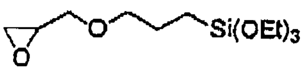 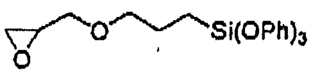 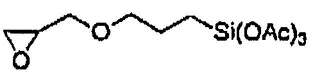

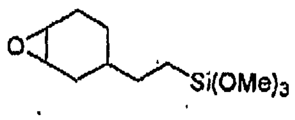 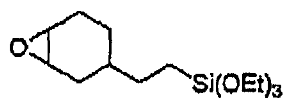

These can be used either alone or as a combination of two or more thereof. Of these, preferred are (3-glycidoxypropyl)trimethoxysilane in which $R^6$ is a 3-glycidoxypropyl group and all $X^2$ groups are methoxy groups, and epoxycyclohexylethyltrimethoxysilane in which $R^6$ is an epoxycyclohexylethyl group and all $X^2$ groups are methoxy groups.

The content of the compound represented by formula (V) in the epoxy group-containing silicon compound is preferably 50% by weight or more, more preferably 80% by weight or more, and still more preferably substantially 100% by weight.

The content of the epoxy group-containing silicon compound is preferably from 0.01 to 90% by weight, more preferably from 0.01 to 50% by weight, and still more preferably from 0.01 to 10% by weight, in the composition.

Further, the content of the epoxy group-containing silicon compound is preferably from 0.001 to 10 parts by weight, and more preferably from 0.01 to 5 parts by weight, based on 100 parts by weight of the dual-end silanol type silicone resin, from the viewpoint of adhesiveness of the resulting cured material.

As an embodiment of the invention, when $X^1$ of the alkenyl group-containing silicon compound and $X^2$ of the epoxy group-containing silicon compound are functional groups to the condensation reaction, from the viewpoint of allowing SiOH groups of the dual-end silanol type silicone oil to react with $SiX^1$ groups of the alkenyl group-containing silicon compound and $SiX^2$ groups of the epoxy group-containing silicon compound in just proportion, the molar ratio ($SiOH(SiX^1+SiX^2)$) of the above-mentioned functional groups is preferably from 20/1 to 0.2/1, more preferably from 10/1 to 0.5/1, and still more preferably substantially equivalent (1/1). When the above-mentioned molar ratio is 20/1 or less,

a semi-cured material having moderate toughness is obtained in the case where the composition of the invention is semi-cured, whereas when it is 0.2/1 or more, the alkenyl group-containing silicon compound and the epoxy group-containing silicon compound do not become too much, resulting in good heat resistance of the resulting resin.

Furthermore, when $X^1$ of the alkenyl group-containing silicon compound and $X^2$ of the epoxy group-containing silicon compound are functional groups to the condensation reaction, the weight ratio of the alkenyl group-containing silicon compound and the epoxy group-containing silicon compound (alkenyl group-containing silicon compound/epoxy group-containing silicon compound) is preferably 200/1 or less, and more preferably 100/1 or less, from the viewpoint of adhesiveness of the resulting cured material. On the other hand, when the above-mentioned weight ratio is preferably 0.1/1 or more, and more preferably 1/1 or more, toughness of the resulting cured material is improved. Accordingly, the above-mentioned weight ratio is preferably from 200/1 to 0.1/1, and more preferably from 100/1 to 1/1.

The thermosetting silicone resin composition of the invention contains the compound readable with both of the monomer relating to the condensation reaction and the monomer relating to the hydrosilylation reaction so that the crosslinking reaction of the monomers is conducted by two kinds of reaction systems different in reaction temperature, that is to say, by the condensation reaction and the addition reaction (hydrosilylation reaction), as described above, thereby adjusting the reaction temperature and controlling the crosslinking reaction to prepare pellets in stage B. That is to say, it is deduced that in the composition of the invention, the resin in the semi-cured state is first prepared by the condensation reaction of the monomer relating to the condensation reaction, followed by the addition reaction of the monomer relating to the hydrosilylation reaction to be able to prepare the completely cured resin. Accordingly, as long as the hydrosilylation reaction is not allowed to occur, the semi-cured state can be maintained, and storage stability in stage B is guaranteed. Incidentally, the composition of the invention is excellent in heat resistance and light resistance, because the silicone-based monomer is used as the resin monomer. In general, the degradation of a silicone resin is enhanced at high temperatures when an acid, an alkali, a metal or the like exists together. Then, in the invention, the platinum-1,3-divinyl-1,1,3,3-tetramethyldisiloxane complex having high reactivity is preferably used as the hydrosilylation catalyst. That is to say, the use of such a catalyst having high reactivity can restrict the amount of the catalyst itself added, and consequently, can inhibit the amount added of the metal enhancing the degradation of the silicone resin, thereby further improving heat resistance of the resulting completely cured material. Incidentally, when the platinum-1,3-divinyl-1,1,3,3-tetramethyldisiloxane complex is used as the hydrosilylation catalyst, pyrolysis at high temperatures is inhibited. Accordingly, stability after the resulting silicone resin cured material has been stored at 200°C for 24 hours is preferably 97% or more, and 99% or more can be kept unpyrolyzed.

As described above, the platinum-1,3-divinyl-1,1,3,3-tetramethyldisiloxane complex has very high reactivity. Accordingly, when the catalyst is used as the hydrosilylation catalyst, the total content of the hydrosilylation catalyst in the composition of the invention can be decreased. In this case, the content of the platinum-1,3-divinyl-1,1,3,3-tetramethyldisiloxane complex in the composition is preferably from $1.0\times10^{4}$ to 5 parts by weight, and more preferably from $1.0\times10^{-4}$ to 0.5 part by weight, based on 100 parts by weight of the organohydrogensiloxane, in terms of the amount of platinum.

Further, the above-mentioned thermosetting silicone resin composition comprising the respective components of the (1) dual-end silanol type silicone oil, the (2) alkenyl group-containing trialkoxysilane, the (3) organohydrogensiloxane, the (4) condensation catalyst, the (5) hydrosilylation catalyst and the epoxy group-containing silicon compound depending on circumstances can be prepared without any particular limitation. However, from the viewpoint of appropriately selecting the reaction temperature and the reaction time depending on the respective reaction mechanisms of the condensation reaction and the addition reaction to allow the reaction to proceed and to be completed, the components relating to the condensation reaction are previously mixed, and then, the components relating to the addition reaction may be mixed. Specifically, mixing can be performed in the following manner.

The mixing of the components relating to the condensation reaction can be performed by stirring the (I) dual-end silanol type silicone oil, the (2) alkenyl group-containing trialkoxysilane, the epoxy group-containing silicon compound depending on circumstances, the (4) condensation catalyst and an additive such as the organic solvent as needed preferably at 0 to 60°C for 5 minutes to 24 hours. Incidentally, the alkenyl group-containing trialkoxysilane is a component relating to both the condensation reaction and the addition reaction. However, it is preferred that the alkenyl group-containing trialkoxysilane is mixed concurrently with the (1) dual-end silanol type silicone oil, because the condensation reaction is started at a lower temperature than the addition reaction.

The existing amount of the organic solvent is preferably from 3 to 20 parts by weight, and more preferably from 5 to 10 parts by weight, based on 100 parts by weight of the total amount of the dual-end silanol type silicone oil and the alkenyl group-containing trialkoxysilane. When the existing amount is 3 parts by weight or more, the reaction proceeds satisfactorily, whereas when it is 20 parts by weight or less, foaming of the composition in the curing step is reduced.

Then, as the components relating to the hydrosilylation reaction, the (3) organohydrogensiloxane and the (5) hydrosilylation catalyst are mixed with the above-mentioned mixture of the components relating to the condensation reaction. In the composition of the invention, when the cured material is obtained by conducting two kinds of reactions, the condensation reaction and the addition reaction, it is possible to prepare a molded product in the semi-cured state

by conducting only the condensation reaction. Accordingly, there is no particular limitation on the mixing method, as long as the components relating to the addition reaction are uniformly mixed with the mixture of the above-mentioned components relating to the condensation reaction.

The viscosity at 25°C of the resulting thermosetting silicone resin composition is preferably from 10 to 100,000 mPa·s, and more preferably from 1,000 to 20,000 mPa·s. In this specification, the viscosity can be measured by using a rheometer.

The silicone resin sheet of the invention is obtained by subjecting the silicone resin composition obtained above to the condensation reaction and forming it into a sheet shape.

Specifically, the above-mentioned silicone resin composition is applied, for example, onto a release sheet (for example, a polyethylene substrate) whose surface is release treated to an appropriate thickness by a method such as casting, spin coating or roll coating, and dried by heating at such a temperature that the solvent is removable, thereby being able to form it into the sheet shape.

The heating temperature cannot be completely determined depending on the kind of solvent used. However, in the composition of the invention, in addition to the removal of the solvent, the condensation reaction is completed by this heating to prepare the silicone resin sheet in the semi-cured state (stage B). The heating temperature is therefore preferably from 40 to 120°C, and more preferably from 60 to 100°C. The heating time is preferably from 0.1 to 60 minutes, and more preferably from 0.1 to 15 minutes. Incidentally, in this specification, "completion of the reaction" means the case where 80% or more of the functional groups relating to the reaction have reacted, and it can be confirmed by measuring the remaining $SiX^1$ group content (and $SiX^2$ group content), SiOH group content or alkoxy group content by the above-mentioned $^1H$-NMR.

The composition of the invention contains the silicone derivative having excellent heat resistance and light resistance as a main component, so that the composition can be suitably used as an encapsulation material of an optical semiconductor element. Accordingly, the invention can provide an optical semiconductor element encapsulation material containing the composition of the invention, and an optical semiconductor device in which the optical semiconductor element is encapsulated by using the encapsulation material.

Further, preferred examples of methods for producing the silicone resin sheet of the invention include a method comprising a step of subjecting the above-mentioned silicone resin composition to the condensation reaction.

Specific examples of the above-mentioned step include, for example, a method of reacting the silicone resin composition containing the condensation reactable substituent group-containing silicon compound and the addition reactable substituent group-containing silicon compound with stirring at a temperature of preferably 40 to 120°C, more preferably 60 to 100°C, for 0.1 to 60 minutes, preferably for 0.1 to 15 minutes.

For example, when an optical semiconductor device is prepared, in order to completely embed an optical semiconductor element mounted on a substrate and to perform encapsulation without deformation and damage of a bonding wire, the resulting silicone resin sheet has a tensile elastic modulus at 25°C of preferably 1,000 to 1,000,000 Pa, more preferably 5,000 to 500,000 Pa, and still more preferably 5,000 to 20,000 Pa. Incidentally, in this specification, the tensile elastic modulus can be measured according to a method described in Examples described later.

Further, from the viewpoints of economic efficiency and handling properties, it is preferred that the silicone resin sheet of the invention can be stored at 25°C for 24 hours or more as it is in the semi-cured state. The silicone resin sheet of the invention after storage at 25°C for 24 hours desirably has an elastic modulus of preferably 80 to 120%, and more preferably 90 to 110%, when the tensile elastic modulus before the storage is taken as 100%.

The silicone resin sheet of the invention is in the semi-cured state, so that, for example, the resin sheet is laminated as such on an optical semiconductor element, followed by performing encapsulation processing, and thereafter, the resin sheet is completely cured by heating at high temperature, thereby being able to prepare an optical semiconductor device. This complete curing of the resin sheet is performed by the reaction of the components relating to the addition reaction. Accordingly, as another embodiment of the invention, there is provided a silicone resin cured material obtained by curing the silicone resin sheet of the invention.

There is no particular limitation on a method for laminating the sheet on the substrate, followed by performing encapsulation processing. For example, there is exemplified a method of pressing the sheet on the substrate by heating preferably at 100 to 200°C and 0.01 to 10 MPa, more preferably at 120 to 160°C and 0.1 to 1 MPa, for 5 to 600 seconds, using a laminator, and then, performing encapsulation processing.

The heating temperature of the encapsulation processing is preferably from 120 to 250°C, and more preferably from 150 to 200°C. The heating time is preferably from 0.5 to 24 hours, and more preferably from 2 to 6 hours.

The progress degree of the addition reaction can be confirmed, for example, when the above-mentioned organohydrogensioxane is used as the addition reaction monomer, by the degree of absorption of a peak derived from the SiH group of the organohydrogensiloxane, according to IR measurement. When the absorption intensity is less than 20% of an initial value (before the curing reaction), the hydrosilylation reaction is completed and the resin sheet is completely cured.

Thus, the encapsulation processing of the optical semiconductor device becomes easy by using the silicone

resin sheet of the invention. Further, the silicone resin sheet of the invention contains the silicone derivative having excellent heat resistance and light resistance as a main component, so that the resin sheet can be suitably used as an encapsulation material of an optical semiconductor element. Accordingly, the invention can provide an optical semiconductor element encapsulation material containing the silicone resin sheet of the invention, and an optical semiconductor device in which the optical semiconductor element is encapsulated by using the encapsulation material.

Further, the silicone resin sheet of the invention has high transparency and good light resistance, so that it is also suitably used for the preparation of a microlens array. As another embodiment of the invention, there is provided a microlens array obtained by molding the silicone resin sheet of the invention. The silicone resin sheet of the invention used for the preparation of the microlens array desirably has a thickness of preferably 50 to 5,000 μm, and more preferably 100 to 4,000 μm.

The microlens array can be prepared by known methods. For example, it can be prepared by a production method comprising (a) a step of preparing a substrate having the same shape as the microlens array, (b) a step of preparing a molding die having a shape reverse to that of the microlens array by using the substrate, and (c) a step of transferring the shape of the microlens array to the resin by using the molding die.

In the step (a), the substrate is preferably Si, quartz glass, a Cu alloy, a Fe alloy, a Ni alloy, a resin plate or film (polyimide, polymethyl methacrylate or the like) or the like. Further, the substrate is preferably prepared by processing to the same shape as the desired microlens array by cutting, etching, radiated light or the like. Microlenses as used herein preferably have a hemispherical shape with a diameter of 0.7 to 50 μm and a height of 0.35 to 25 μm. The microlens array is preferably one in which the above-mentioned microlenses are arranged at constant pitches and/or closest packing.

In the step (b), the molding die having the shape reverse to that of the substrate having the shape of the microlens array can be prepared by electrolytically plating a metal on a surface of the substrate to a thickness of preferably 0.15 to 0.5 mm by electrocasting using Au, Ag, Al, Cr, Ni, and then, releasing the plated metal from the substrate.

In the step (c), the shape of the microlens array is preferably transferred to the resin, that is to say, the silicone resin sheet of the invention by using the molding die. Specifically, the silicone resin sheet of the invention is laminated on a quartz plate, and then, the molding die is disposed on the sheet. Pressing is performed with a vacuum laminator at 0.1 to 1.0 MPa and 100 to 180°C for 0.5 to 5 minutes, thereby being able to transfer the shape of the microlens array to the resin sheet.

Further, the step (c) may comprise a step of applying the resin to the substrate, a step of pressing the resin to a surface of the molding die, on which the shape reverse to that of the microlens array is formed, and a step of curing the resin.

The microlens array of the invention can be suitably used, for example, in optical electronic devices such as liquid crystal projectors, video cameras, view finders and potable TVs.

## Examples

The invention will be described below with reference to examples.

### Molecular Weight of Silicone Derivative

The molecular weight is determined in terms of polystyrene by gel filtration chromatography (GPC).

### Viscosity of Composition

The viscosity is measured by using a rheometer under conditions of 25°C and 1 atm.

### Tensile Elastic Modulus of Resin Sheet

Viscoelasticity measurement at the time of shear is made with a dynamic viscoelasticity measuring instrument (DMS-200, manufactured by SII Nanotechnology Inc.), and from the measurement results, the storage elastic modulus at 25°C is taken as the tensile elastic modulus of the resin sheet.

### Example 1

A hundred grams (8.70 mmol) of a dual-end silanol type silicone oil (manufactured by Shin-Etsu Chemical Co., Ltd., trade name: X-21-5842, average molecular weight: 11,500), 0.86 g (5.80 mmol) of vinyltrimethoxysilane (manufactured by Shin-Etsu Chemical Co., Ltd., trade name: KBM-1003) (wherein the molar ratio (SiOH/methoxy) of SiOH groups of the dual-end silanol type silicone oil and methoxy groups of vinyltrimethoxysilane = 17/17), and 10 ml (8 parts

by weight based on 100 parts by weight of the total amount of the dual-end silanol type silicone oil and vinyltrimethoxysilane) of 2-propanol were mixed by stirring, and then, 0.16 ml (0.17 mmol, 2.0 moles based on 100 moles of the dual-end silanol type silicone oil) of an aqueous tetramethylammonium hydroxide solution (concentration: 10% by weight) was added thereto as a condensation catalyst, followed by stirring at room temperature (25°C) for 2 hours.

To the resulting oil, 0.75 g of an organohydrogenpolysiloxane (manufactured by Shin-Etsu Chemical Co., Ltd., trade name: KF-9901) (wherein the molar ratio (vinyl/SiH) of vinyl groups of vinyltrimethoxysilane and SiH groups of the organohydrogenpolysiloxane = 1/1) and 0.26 ml (35 parts by weight based on 100 parts by weight of the organohydrogenpolysiloxane) of a platinum carbonyl complex solution (platinum concentration: 2% by weight) as a hydrosilylation catalyst were added to obtain a silicone resin composition.

Example 2

A hundred grams (8.70 mmol) of a dual-end silanol type silicone oil (manufactured by Shin-Etsu Chemical Co., Ltd., trade name: X-21-5842, average molecular weight: 11,500), 0.86 g (5.80 mmol) of vinyltrimethoxysilane (manufactured by Shin-Etsu Chemical Co., Ltd., trade name: KBM-1003) (wherein the molar ratio (SiOH/methoxy)of SiOH groups of the dual-end silanol type silicone oil and methoxy groups of vinyltrimethoxysilane = 17/17), and 10 ml (8 parts by weight based on 100 parts by weight of the total amount of the dual-end silanol type silicone oil and vinyltrimethoxysilane) of 2-propanol were mixed by stirring, and then, 0.16 ml (0.17 mmol, 2.0 moles based on 100 moles of the dual-end silanol type silicone oil) of an aqueous tetramethylammonium hydroxide solution (concentration: 10% by weight) was added thereto as a condensation catalyst, followed by stirring at room temperature (25°C) for 2 hours.

To the resulting oil, 0.090 g of an organohydrogenpolysiloxane (manufactured by Shin-Etsu Chemical Co., Ltd., trade name: KF-99) (wherein the molar ratio (vinyl group/SiH) of vinyl groups of vinyltrimethoxysilane and SiH groups of the organohydrogenpolysiloxane = 1/1) and 0.26 ml (289 parts by weight based on 100 parts by weight of the organohydrogenpolysiloxane) of a platinum carbonyl complex solution (platinum concentration: 2% by weight) as a hydrosilylation catalyst were added to obtain a silicone resin composition.

Comparative Example 1

Ten grams of liquid A and 10 g of liquid B of a two-liquid mixing type silicone elastomer (manufactured by Wacker Asahikasei Silicone Co., Ltd., a heat-curing type high-viscosity commercial product were thoroughly mixed to obtain a silicone resin composition.

Preparation of Semi-Cured Material

Using the respective silicone resin compositions obtained above, resin sheets in a semi-cured state were prepared. Specifically, each of the above-mentioned compositions was applied on a biaxially oriented polyester film (manufactured by Mitsubishi Chemical Polyester Film Co., Ltd., 50 μm) to a thickness of 500 μm. Then, the compositions obtained in Examples 1 and 2 were heated at 80°C for 10 minutes, and the composition obtained in Comparative Example 1 was allowed to stand at room temperature (25°C) for 16 hours, thereby preparing resin sheets.

Preparation of Completely Cured material

Using the sheets in the semi-cured state of Examples 1 and 2 and Comparative Example 1 obtained above, the sheets of Examples 1 and 2 were heated at 150°C for 4 hours, and the sheet of Comparative Example 1 was heated at 150°C for 1 hour, thereby preparing completely cured materials.

Preparation of Optical Semiconductor Device

A substrate on which a blue LED was mounted was coated with each of the sheets of Examples 1 and 2 and Comparative Example 1, followed by heating under reduced pressure at 160°C for 5 minutes to perform encapsulation processing at a pressure of 0.2 MPa. The resulting device was heated at 150°C for 1 hour, thereby completely curing the resin.

For the resulting sheets, completely cured materials and semiconductor devices, characteristics were evaluated according to the following test examples. The results thereof are shown in Table 1.

Test Example 1 (Storage Property)

Each sheet was allowed to stand at room temperature (25°C), and changes in elastic modulus thereof after 24

hours were examined. When the elastic modulus before storage was taken as 100%, the case where the rate of change in elastic modulus after an elapse of 24 hours was less than 3% (the elastic modulus after storage was more than 97% or less than 103%) was evaluated as "A", the case where it was from 3 to 20% (the elastic modulus after storage was from 80 to 97% or from 103 to 120%) was evaluated as "B", and the case where it exceeded 20% (the elastic modulus after storage was from less than 80% or more than 120%) was evaluated as "C".

Test Example 2 (Light Transmittance)

The light transmittance (%) of each completely cured material at a wavelength of 450 nm was measured by using a spectrophotometer (U-4100, manufactured by Hitachi High-Technologies Corporation)

Test Example 3 (Heat Resistance)

Each completely cured material was allowed to stand still in a hot air type dryer of 150°C, and transparency of the completely cured material after an elapse of 100 hours was visually observed. The case where no change in color from a state before storage was observed was evaluated as "A", and the case where a change in color was observed was evaluated as "B".

Test Example 4 (Encapsulation Property)

States of each semiconductor device before and after encapsulation were observed under an optical microscope. The case where the semiconductor element was completely embedded and no deformation and damage were observed was evaluated as "A", and the case where deformation and damage were observed was evaluated as "B".

Test Example 5 (Light Resistance)

An electric current of 300 mA was applied to each semiconductor device to light a LED element, and the luminance thereof immediately after the test was started was measured with an instantaneous multiple photometric system (MCPD-3000, manufactured by Otsuka Electronics Co., Ltd.). Then, the LED element was allowed to stand in a state where it was lighted, and the luminance after an elapse of 300 hours was similarly measured. The luminance retention was calculated by the following equation, and the light resistance was evaluated. The higher luminance retention shows the more excellent heat resistance.

$$\text{Luminance retention (\%)} = (\text{luminance after an elapse of 300 hours/luminance immediately after the test was started}) \times 100$$

Table 1

| | | Example 1 | Example 2 | Comparative Example 1 |
|---|---|---|---|---|
| Composition | Condensation Reaction Monomer/Addition Reaction Monomer[1] | 99.3/0.7 | 99.9/0.1 | - |
| | Viscosity (mPa·s) (25°C) | 2000 | 2500 | 15000 |
| Condensation Reaction Temperature | | 80 | 80 | 25 |
| Sheet | Tensile Elastic Modulus Immediately after Preparation (Pa) | 9000 | 8700 | 10000 |
| | Tensile Elastic Modulus after Storage (Pa) | 9200 | 9300 | 45000 |
| | Storage Property | A | B | C |
| Completely Cured Material | Light Transmittance (%) | 99 | 99 | 99 |
| | Heat resistance | A | A | A |

(continued)

| | | Example 1 | Example 2 | Comparative Example 1 |
|---|---|---|---|---|
| Semiconductor Device | Encapsulation Property | A | A | B |
| | Luminance Retention (%) | >99 | >99 | >99 |
| 1) The weight ratio (condensation reaction monomer/addition reaction monomer) of the condensation reactable substituent group-containing silicon compound (condensation reaction monomer) and the addition reactable substituent group-containing silicon compound (addition reaction monomer) | | | | |

As a result, it is known that the silicone resin sheets obtained in Examples 1 and 2 are high in storage property even in the semi-cured state compared to the silicone resin sheet obtained in Comparative Example 1, and further can encapsulate the LED element simply and satisfactorily, so that they are excellent encapsulation materials.

Example 3

Two hundred grams (17.4 mmol) of a dual-end silanol type silicone oil (a compound in which $R^1$ groups in formula (I) are all represented by methyl groups, average molecular weight: 11,500), 1.75 g (11.8 mmol) of vinyltrimethoxysilane (a compound in which $R^2$ groups in formula (II') is represented by a vinyl group and $R^3$ groups in formula (II') are all represented by methyl groups) as an alkenyl group-containing trialkoxysilane (wherein the molar ratio ($SiOH/SiOR^3$) of SiOH groups of the dual-end silanol type silicone oil and $SiOR^3$ groups of the alkenyl group-containing trialkoxysilane = 35/35), and 20 ml (8 parts by weight based on 100 parts by weight of the total amount of the dual-end silanol type silicone oil and the alkenyl group-containing trialkoxysilane) of 2-propanol were mixed by stirring, and then, 0.32 ml (0.35 mmol), 2.0 moles based on 100 moles of the dual-end silanol type silicone oil) of an aqueous tetramethylammonium hydroxide solution (concentration: 10% by weight) was added thereto as a condensation catalyst, followed by stirring at room temperature (25°C) for 2 hours.

To the resulting oil, 1.50 g of an organohydrogensiloxane (a compound in which $R^4$ groups in formula (III) are all represented by methyl groups, a is represented by 10 and b is represented by 10, viscosity: 20 mPa·s) (wherein the molar ratio ($SiR^2/SiH$) of $SiR^2$ groups of the alkenyl group-containing trialkoxysilane and SiH groups of the organohydrogensiloxane = 1/1) and 1.05 ml (platinum content: 1.4 parts by weight based on 100 parts by weight of the organohydrogensiloxane) of a platinum carbonyl complex solution (platinum concentration: 2% by weight) as a hydrosilylation catalyst were added to obtain a silicone resin composition.

Example 4

Twenty grams (1.74 mmol) of a dual-end silanol type silicone oil (a compound in which $R^1$ groups in formula (I) are all represented by methyl groups, average molecular weight: 11,500), 0.18 g (1.21 mmol) of vinyltrimethoxysilane (a compound in which $R^2$ in formula (II') is represented by a vinyl group and $R^3$ groups in formula (II') are all represented by methyl groups) as an alkenyl group-containing trialkoxysilane (wherein the molar ratio ($SiOH/SiOR^3$)of SiOH groups of the dual-end silanol type silicone oil and $SiOR^3$ groups of the alkenyl group-containing trialkoxysilane = 3.5/3.6), and 2.0 ml (8 parts by weight based on 100 parts by weight of the total amount of the dual-end silanol type silicone oil and the alkenyl group-containing trialkoxysilane) of 2-propanol were mixed by stirring, and then, 0.032 ml (0.035 mmol, 2.0 moles based on 100 moles of the dual-end silanol type silicone oil) of an aqueous tetramethylammonium hydroxide solution (concentration: 10% by weight) was added thereto as a condensation catalyst, followed by stirring at room temperature (25°C) for 2 hours.

To the resulting oil, 0.073 g of an organohydrogensiloxane (a compound in which $R^4$ groups in formula (III) are all represented by methyl groups, a is represented by 0 and b is represented by 20, viscosity: 20 mPa·s) (wherein the molar ratio ($SiR^2/SiH$) of $SiR^2$ groups of the alkenyl group-containing trialkoxysilane and SiH groups of the organohydrogensiloxane = 1/1) and 0.10 ml (platinum content: 2.7 parts by weight based on 100 parts by weight of the organohydrogensiloxane) of a platinum carbonyl complex solution (platinum concentration: 2% by weight) as a hydrosilylation catalyst were added to obtain a silicone resin composition.

Example 5

Twenty grams (6.67 mmol) of a dual-end silanol type silicone oil (a compound

in which $R^1$ groups in formula (I) are all represented by methyl groups, average molecular weight: 3,000), 0.66 g (4.45 mmol) of vinyltrimethoxysilane (a compound in which $R^2$ in formula (II') is represented by a vinyl group and $R^3$ groups in formula (II') are all represented by methyl groups) as an alkenyl group-containing trialkoxysilane (wherein the molar ratio ($SiOH/SiOR^3$) of SiOH groups of the dual-end silanol type silicone oil and $SiOR^3$ groups of the alkenyl group-containing trialkoxysilane = 13/13), and 2.0 ml (8 parts by weight based on 100 parts by weight of the total amount of the dual-end silanol type silicone oil and the alkenyl group-containing trialkoxysilane) of 2-propanol were mixed by stirring, and then, 0.032 ml (0.035 mmol, 0.5 mole based on 100 moles of the dual-end silanol type silicone oil) of an aqueous tetramethylammonium hydroxide solution (concentration: 10% by weight) was added thereto as a condensation catalyst, followed by stirring at room temperature (25°C) for 2 hours.

To the resulting oil, 0.63 g of an organohydrogensiloxane (a compound in which $R^4$ groups in formula (III) are all represented by methyl groups, a is represented by 10 and b is represented by 10, viscosity: 20 mPa·s) (wherein the molar ratio ($SiR^2/SiH$) of $SiR^2$ groups of the alkenyl group-containing trialkoxysilane and SiH groups of the organohydrogensiloxane = 1/1) and 0.10 ml (platinum content: 0.32 part by weight based on 100 parts by weight of the organohydrogensiloxane) of a platinum carbonyl complex solution (platinum concentration: 2% by weight) as a hydrosilylation catalyst were added to obtain a silicone resin composition.

Example 6

A hundred grams (8.70 mmol) of a dual-end silanol type silicone oil (a compound in which $R^1$ groups in formula (I) are all represented by methyl groups, average molecular weight: 11,500), 0.86 g (5.8 mmol) of vinyltrimethoxysilane (a compound in which $R^2$ in formula (II') is represented by a vinyl group and $R^3$ groups in formula (II') are all represented by methyl groups) as an alkenyl group-containing trialkoxysilane (wherein the molar ratio ($SiOH/SiOR^3$) of SiOH groups of the dual-end silanol type silicone oil and $SiOR^3$ groups of the alkenyl group-containing trialkoxysilane = 17/17), and 10 ml (8 parts by weight based on 100 parts by weight of the total amount of the dual-end silanol type silicone oil and the alkenyl group-containing trialkoxysilane) of 2-propanol were mixed by stirring, and then, 0.16 ml (0.17 mmol, 2.0 moles based on 100 moles of the dual-end silanol type silicone oil) of an aqueous tetramethylammonium hydroxide solution (concentration: 10% by weight) was added thereto as a condensation catalyst, followed by stirring at room temperature (25°C) for 2 hours.

To the resulting oil, 2.25 g of an organohydrogensiloxane (a compound in which $R^4$ groups in formula (III) are all represented by methyl groups, a is represented by 10 and b is represented by 10, viscosity: 20 mPa·s) (wherein the molar ratio ($SiR^2/SiH$) of $SiR^2$ groups of the alkenyl group-containing trialkoxysilane and SiH groups of the organohydrogensiloxane = 1/3) and 0.53 ml (platinum content: 0.47 part by weight based on 100 parts by weight of the organohydrogensiloxane) of a platinum carbonyl complex solution (platinum concentration: 2% by weight) as a hydrosilylation catalyst were added to obtain a silicone resin composition.

Example 7

A hundred grams (8.70 mmol) of a dual-end silanol type silicone oil (a compound in which $R^1$ groups in formula (I) are all represented by methyl groups, average molecular weight: 11,500), 0.86 g (5.8 mmol) of vinyltrimethoxysilane (a compound in which $R^2$ in formula (II') is represented by a vinyl group and $R^3$ groups in formula (II') are all represented by methyl groups) as an alkenyl group-containing trialkoxysilane) (wherein the molar ratio ($SiOH/SiOR^3$) of SiOH groups of the dual-end silanol type silicone oil and $SiOR^3$ groups of the alkenyl group-containing trialkoxysilane = 17/17), and 10 ml (8 parts by weight based on 100 parts by weight of the total amount of the dual-end silanol type silicone oil and the alkenyl group-containing trialkoxysilane) of 2-propanol were mixed by stirring, and then, 0.19 ml (0.17 mmol, 2.0 moles based on 100 moles of the dual-end silanol type silicone oil) of a methanol solution of tetramethylammonium hydroxide (concentration: 10% by weight) was added thereto as a condensation catalyst, followed by stirring at room temperature (25°C) for 2 hours.

To the resulting oil, 0.75 g of an organohydrogensiloxane (a compound in which $R^4$ groups in formula (III) are all represented by methyl groups, a is represented by 10 and b is represented by 10, viscosity: 20 mPa·s) (wherein the molar ratio ($SiR^2/SiH$) of $SiR^2$ groups of the alkenyl group-containing trialkoxysilane and SiH groups of the organohydrogensiloxane = 1/3) and 0.53 ml (platinum content: 1.4 parts by weight based on 100 parts by weight of the organohydrogensiloxane) of a platinum carbonyl complex solution (platinum concentration: 2% by weight) as a hydrosilylation catalyst were added to obtain a silicone resin composition.

Preparation of Semi-Cured Material

Using the silicone resin compositions obtained in Examples 3 to 7 and Comparative Example 1 described above, semi-cured materials were prepared in the same manner as described above. Specifically, each of the above-mentioned compositions was applied on a biaxially oriented polyester film (manufactured by Mitsubishi Chemical Polyester Film Co., Ltd., 50 μm) to a thickness of 500 μm. Then, the compositions obtained in Examples 3 to 5 were heated at 80°C for 10 minutes, the compositions in Examples 6 and 7 were heated at 80 °C for 5 minutes, and the composition obtained in Comparative Example I was allowed to stand at room temperature (25°C) for 16 hours, thereby preparing sheet-like semi-cured materials.

Preparation of Completely Cured material

Using the semi-cured materials of Examples 3 to 7 and Comparative Example 1 obtained above, the semi-cured materials of Examples were heated at 150°C for 4 hours, and the semi-cured material of Comparative Example 1 was heated at 150°C for 1 hour, thereby preparing completely cured materials.

Preparation of Optical Semiconductor Device

A substrate on which a blue LED was mounted was coated with each of the resin sheets in the semi-cured state of Examples 3 to 7 and Comparative Example 1 under heat pressing conditions, followed by encapsulation processing under the same conditions as in the preparation of the above-mentioned optical semiconductor devices. The resulting device was heated at 150°C for 1 hour, thereby completely curing the resin.

For the resulting semi-cured materials, completely cured materials and semiconductor devices, characteristics were evaluated according to the above-mentioned Test Examples 1 to 5. The results thereof are shown in Table 2.

Table 2

| | | Example 3 | Example 4 | Example 5 | Example 6 | Example 7 | Comparative Example 1 |
|---|---|---|---|---|---|---|---|
| Composition | Dual-end Silanol Type Silicone Oil/Organohydrogen siloxane[1)] | 99.3/0.7 | 99.6/0.4 | 96.9/3.1 | 97.8/2.2 | 99.3/0.7 | - |
| | Viscosity (mPa·s)(25°C) | 2000 | 2400 | 1800 | 2800 | 3000 | 15000 |
| Sheet | Tensile Elastic Modulus Immediately after Preparation (Pa) | 9000 | 8700 | 9300 | 9200 | 10200 | 10000 |
| | Tensile Elastic Modulus after Storage (Pa) | 9200 | 9200 | 9500 | 9200 | 9800 | 45000 |
| | Storage Property | A | B | A | A | B | C |
| Completely Cured Material | Light Transmittance (%) | 98.5 | 98.5 | 98.6 | 98.5 | 99.1 | 98.5 |
| | Heat resistance | A | A | A | A | A | A |
| Semiconduc tor Device | Encapsulation Property | A | A | A | A | A | B |
| | Luminance Retention (%) | >99 | >99 | >99 | >99 | >99 | >99 |

1) The weight ratio (dual-end silanol type silicone oil/organohydrogensiloxane) of the dual-end silanol type silicone oil and the organohydrogensiloxane

As is clear from the results of Table 2, it is known that the compositions of Examples 3 to 7 are high in storage property even in the semi-cured state compared to the composition of Comparative Example 1, and further can encapsulate the LED element simply and satisfactorily, so that they are excellent encapsulation materials.

Further, in the compositions of Examples 6 and 7, the molar ratio ($SiR^2/SiH$) of $SiR^2$ groups of the alkenyl group-containing trialkoxysilane and SiH groups of the organohydrogensiloxane is 1/3, and in the compositions of Examples 3 to 5, the molar ratio is 1/1. It has become clear that the curing rate at the time when the semi-cured material is prepared from the composition is improved by increasing the SiH content of the organohydrogensiloxane. Furthermore, from the results of Example 7, it is also known that the transparency of the cured material is improved by using the methanol solution of the tetramethylammonium hydroxide as the condensation catalyst.

Example 8

Two hundred grams (17.4 mmol) of a dual-end silanol type silicone oil (a compound in which $R^1$ groups in formula (I) are all represented by methyl groups, average molecular weight: 11,500), 1.75 g (11.8 mmol) of vinyltrimethoxysilane (a compound in which $R^2$ in formula (II) is represented by a vinyl group, and $X^1$ groups are all represented by methoxy groups) as an alkenyl group-containing silicon compound (wherein the molar ratio ($SiOH/SiX^1$) of SiOH groups of the dual-end silanol type silicone oil and $SiX^1$ groups of the alkenyl group-containing silicon compound = 35/35), and 2.0 ml (8 parts by weight based on 100 parts by weight of the total amount of the dual-end silanol type silicone oil and the alkenyl group-containing silicon compound) of 2-propanol were mixed by stirring, and then, 0.32 ml (0.35 mmol, 2.0 moles based on 100 moles of the dual-end silanol type silicone oil) of an aqueous tetramethylammonium hydroxide solution (concentration: 10% by weight) was added thereto as a condensation catalyst, followed by stirring at room temperature (25°C) for 1 hour.

To the resulting oil, 1.50 g of an organohydrogensiloxane (a compound in which $R^4$ groups in formula (III) are all represented by methyl groups, a is represented by 0 and b is represented by 2, viscosity: 20 mPa·s) (wherein the molar ratio ($SiR^2/SiH$) af $SiR^2$ groups of the alkenyl group-containing silicon compound and SiH groups of the organohydrogensiloxane = 1/1) and 0.10 ml (platinum content: 0.14 part by weight based on 100 parts by weight of the organohydrogensiloxane) of a platinum-1,3-divinyl-1,1,3,3-tetramethyldisiloxane complex (platinum concentration: 2% by weight) as a hydrosilylation catalyst were added to obtain a silicone resin composition.

Example 9

Twenty grams (6.67 mmol) of a dual-end silanol type silicone oil (a compound in which $R^1$ groups in formula (I) are all represented by methyl groups, average molecular weight: 3,000), 0.66 g (4.45 mmol) of vinyltrimethoxysilane (a compound in which $R^2$ in formula (II) is represented by a vinyl group, and $X^1$ groups are all represented by methoxy groups) as an alkenyl group-containing silicon compound (wherein the molar ratio ($SiOH/SiX^1$) of SiOH groups of the dual-end silanol type silicone oil and $SiX^1$ groups of the alkenyl group-containing silicon compound = 13/13), and 2.0 ml (8 parts by weight based on 100 parts by weight of the total amount of the dual-end silanol type silicone oil and the alkenyl group-containing silicon compound) of 2-propanol were mixed by stirring, and then, 0.032 ml (0.035 mmol, 0.5 mole based on 100 moles of the dual-end silanol type silicone oil) of an aqueous tetramethylammonium hydroxide solution (concentration: 10% by weight) was added thereto as a condensation catalyst, followed by stirring at room temperature (25°C) for 1 hour.

To the resulting oil, 0.63 g of an organohydrogensiloxane (a compound in which $R^4$ groups in formula (III) are all represented by methyl groups, a is represented by 0 and b is represented by 2, viscosity: 20 mPa·s) (wherein the molar ratio ($SiR^2/SiH$) of $SiR^2$ groups of the alkenyl group-containing silicon compound and SiH groups of the organohydrogensiloxane = 1/1) and 0.01 ml (platinum content: 0.04 part by weight based on 100 parts by weight of the organohydrogensiloxane) of a platinum-1,3-divinyl-1,1,3,3-tetramethyldisiloxane complex (platinum concentration: 2% by weight) as a hydrosilylation catalyst were added to obtain a silicone resin composition.

Comparative Example 2

Twenty grams of an organohydrogensiloxane (a compound in which $R^4$ groups in formula (III) are all represented by methyl groups, a is represented by 0 and b is represented by 2, viscosity: 20 mPa·s), 1.2 g (3.5 mmol) of 1,3,5,7-tetravinyl-1,3,5,7-tetramethylcyclotetrasiloxane and 0.01 ml (platinum content: 0.02 part by weight based on 100 parts by weight of the organohydrogensiloxane) of a platinum-1,3-divinyl-1,1,3,3-tetramethyldisiloxane complex (platinum concentration: 2% by weight) were thoroughly mixed to obtain a silicone resin composition.

Comparative Example 3

A silicone resin composition was obtained in the same manner as in Example 8 with the exception that 0.1 ml of a platinum-carbonyl complex (manufactured by Gelest, Inc., SIP6829.2, platinum concentration: 2% by weight) was used in place of 0.10 ml of platinum-1,3-divinyl-1,1,3,3-tetramethyldisiloxane complex (platinum concentration: 2% by weight).

Preparation of Semi-Cured Material

Using the silicone resin compositions obtained in Examples 8 and 9 and Comparative Examples 2 and 3 described above, semi-cured materials were prepared in the same manner as in Examples described above.

Preparation of Completely Cured Material

Using the semi-cured materials of Examples 8 and 9 and Comparative Examples 2 and 3 obtained above, completely cured materials were prepared under the same heating conditions as in Examples described above.

Preparation of Optical Semiconductor Device

A substrate on which a blue LED was mounted was coated with each of the resin sheets in the semi-cured state of Examples 8 and 9 and Comparative Examples 2 and 3 under heat pressing conditions, followed by encapsulation processing under the same conditions as in the preparation of the above-mentioned optical semiconductor devices. The resulting device was heated at 150°C for 1 hour, thereby completely curing the resin.

For the resulting completely cured materials and semiconductor devices, characteristics were evaluated according to the above-mentioned Test Example 2 (light transmittance), Test Example 3 (heat resistance) and Test Example 5 (light resistance). The results thereof are shown in Table 3. Incidentally, in respect to the heat resistance test of Test Example 3, the storage time was changed from 100 hours to 24 hours, and the residual rate was also measured as described below.

Residual Rate

The completely cured material was allowed to stand still in a hot air type dryer of 200°C, and the weight thereof after an elapse of 24 hours was measured. The weight of the completely cured material after an elapse of 24 hours divided by the weight thereof before storage was taken as the residual rate (%). No change in appearance after storage and the higher storage rate show the more excellent heat resistance.

Table 3

| | | Example 8 | Example 9 | Comparative Example 2 | Comparative Example 3 |
|---|---|---|---|---|---|
| Composition | (1) Dual-end Silanol Type Silicone Oil | Compound in which all $R^1$ groups in formula (I) are methyl (average molecular weight: 11500) | Compound in which all $R^1$ groups in formula (I) are methyl (average molecular weight; 3000) | - | Compound in which all $R^1$ groups in formula (I) are methyl (average molecular weight: 11500) |
| | (2) Alkenyl Group-Containing Silicon Compound | Vinyltrimethoxysilane | Vinyltrimethoxysilane | 1,3,5,7-Tetravinyl-1,3,5,7-tetramethylcyclotetrasiloxane | Vinyltrimethoxysilane |
| | (3) Organohydrogensiloxane | Compound in which all $R^4$ groups in formula (III) are methyl (average molecular weight: ca. 1500) | Compound in which all $R^4$ groups in formula (III) are methyl (average molecular weight: ca. 1500) | Compound in which all $R^4$ groups in formula (III) are methyl (average molecular weight: ca. 1500) | Compound in which all $R^4$ groups in formula (III) are methyl (average molecular weight: ca. 1500) |
| | (4) Condensation Catalyst | Tetramethylammonium hydroxide | Tetramethylammonium hydroxide | Tetramethylammonium hydroxide | Tetramethylammonium hydroxide |
| | (5) Hydrosilylation Catalyst | Pt-TMDS complex | Pt-TMDS complex | Pt-TMDS complex | Pt-carbonyl complex |
| | Silicone Oil/Siloxane[1)] | 99.3/0.7 | 96.9/3.1 | - | 99.3/0.7 |
| | Hydrosilylation Catalyst Content[2)] | 7 | 2 | 1 | 7 |
| | Platinum Content[3)] | 0.14 | 0.04 | 0.02 | 0.14 |
| Completely Cured Material | Light Transmittance (%) | 99 | 99 | 99 | 99 |
| | Heat Resistance (Appearance) | A | A | A | A |
| | Heat Resistance (Residual Rate, %) | 99.2 | 99.0 | 91.0 | 98.5 |

(continued)

| | | Example 8 | Example 9 | Comparative Example 2 | Comparative Example 3 |
|---|---|---|---|---|---|
| Semiconduct or Device | Luminance Retention (%) | >99 | >99 | 95 | >99 |

Pt-TMDS complex: platinum-1,3-divinyl-1,1,3,3-tetramethylsiloxane complex
Pt-carbonyl complex: platinum-carbonyl complex
1) The weight ratio (silicone oil/siloxane) of the dual-end silanol type silicone oil and the organohydrogensiloxane
2) The content shows the amount (parts by weight) used based on 100 parts by weight of the organohydrogensiloxane.
3) The content shows the amount (parts by weight) used based on 100 parts by weight of the organohydrogensiloxane.

As is clear from the results of Table 3 described above, it is known that the resin compositions of Examples 8 and 9 can form the semi-cured state, and are excellent in all of light transparency, heat resistance and light resistance, compared to the composition of Comparative Example 3, so that they are excellent encapsulation materials.

Example 10

A silicone resin composition having a composition shown in Table 4 was obtained. Specifically, 100 g (8.70 mmol) of a dual-end silanol type silicone oil (a compound in which $R^1$ groups in formula (I) are all represented by methyl groups, and n is represented by 155, average molecular weight: 11,500), 0.77 g (5.20 mmol) of vinyltrimethoxysilane (a compound in which $R^2$ in formula (II) is represented by a vinyl group, and $X^1$ groups are all represented by methoxy groups) as an alkenyl group-containing silicon compound, and 0.14 g (0.59 mmol) of (3-glycidoxypropyl)trimethoxysilane (a compound in which $R^6$ in formula (V) is represented by a 3-glycidoxypropyl group, and $X^2$ groups are all represented by methoxy groups) as an epoxy group-containing silicon compound (wherein the molar ratio ($SiOH/SiX^1+SiX^2$) of SiOH groups of the dual-end silanol type silicone oil and total number of moles of $SiX^1$ groups of the alkenyl group-containing silicon compound and $SiX^2$ groups of the epoxy group-containing silicon compound = 1/1) were mixed by stirring, and then, 0.19 ml (catalytic amount: 0.17 mmol, 2.0 moles based on 100 moles of the dual-end silanol type silicone oil) of a methanol solution of tetramethylammonium hydroxide (concentration: 10% by weight) was added thereto as a condensation catalyst, followed by stirring at room temperature (25°C) for 1 hour.

To the resulting oil, 2.19 g of an organohydrogensiloxane (a compound in which $R^4$ groups in formula (III) are all represented by methyl groups, a is represented by 10 and b is represented by 10, viscosity: 20 mPa·s) (wherein the molar ratio ($SiR^2/SiH$) of $SiR^2$ groups of the alkenyl group-containing silicon compound and SiH groups of the organohydrogensiloxane = 1/3.0) and 0.025 ml (platinum content: 0.02 part by weight based on 100 parts by weight of the organohydrogensiloxane) of a platinum-1,3-divinyl-1,1,3,3-tetramethyldisiloxane complex (platinum concentration: 2% by weight) as a hydrosilylation catalyst were added to obtain a silicone resin composition.

Example 11

A silicone resin composition was obtained in the same manner as in Example 10 with the exceptions that the amount of vinyltrimethoxysilane used was changed from 0.77 g (5.20 mmol) to 0.85 g (5.70 mmol) and that the amount of (3-glycidoxypropyl)trimethoxysilane used was changed from 0.14 g (0.59 mmol) to 0.014 g (0.059 mmol). Incidentally, the molar ratio ($SiOH/SiX^1+SiX^2$) was 1/1, and the molar ratio ($SiR^2/SiH$) was 1/2.7.

Example 12

A silicone resin composition was obtained in the same manner as in Example 10 with the exception that 0.15 g (0.59 mmol) of (epoxycyclohexyl)ethyltrimethoxysilane (a compound in which $R^6$ in formula (V) is represented by an (epoxycyclohexyl)ethyl group, and $X^2$ goups are all represented by methoxy groups) was used in place of 0.14 g (0.59 mmol) of (3-glycidoxypropyl)trimethoxysilane. Incidentally, the molar ratio ($SiOH/SiX^1+SiX^2$) was 1/1, and the molar ratio ($SiR^2/SiH$) was 1/3.0.

Comparative Example 4

A silicone resin composition was obtained in the same manner as in Example 10 with the exceptions that the amount of vinyltrimethoxysilane used was changed from 0.77 g (5.20 mmol) to 0.86 g (5.80 mmol) and that 0.14 g (0.59 mmol) of (3-glycidoxypropyl)trimethoxysilane was not used. Incidentally, the molar ratio ($SiOH/SiX^1$) was 1/1, and the molar ratio ($SiR^2/SiH$) was 1/2.7.

Table 4

| | | Example 10 | Example 11 | Example 12 | Comparative Example 4 |
|---|---|---|---|---|---|
| Composition | (1) Dual-end Silanol Type Silicone Oil | Compound in which all $R^1$ groups in formula (I) are methyl (n=155) | Compound in which all $R^1$ groups in formula (I) are methyl (n=155) | Compound in which all $R^1$ groups in formula (I) are methyl (n=155) | Compound in which all $R^1$ groups in formula (I) are methyl (n=155) |
| | (2) Alkenyl Group-Containing Silicon Compound | Vinyltrimethoxysilane | Vinyltrimethoxysilane | Vinyltrimethoxysilane | Vinyltrimethoxysilane |
| | (3) Epoxy Group-Containing Silicon Compound | (3-Glycidoxypropyl) trimethoxysilane | (3-Glycidoxypropyl) trimethoxysilane | (epoxycyclohexyl) ethylmetlioxysilane | - |
| | (4) Organohydrogensiloxane | Compound in which all $R^4$ groups in formula (III) are methyl, a=10 and b=10 | Compound in which all $R^4$ groups in formula (III) are methyl, a=10 and b=14 | Compound in which all $R^4$ groups in formula (III) are methyl, a=10 and b=10 | Compound in which all $R^4$ groups in formula (III) are methyl, a=10 and b=10 |
| | (5) Condensation Catalyst | Tetramethylammonium hydroxide | Tetramethylammonium hydroxide | Tetramethylammonium hydroxide | Tetramethylammonium hydroxide |
| | (6) Hydrosilylation Catalyst | Pt-TMDS complex | Pt-TMDS complex | Pt-TMDS complex | Pt-TMDS complex |
| Viscosity (mPa·s)(25°C) | 5400 | 6200 | 4000 | 7000 | |
| (2) Content[1)] | 0.77 | 0.85 | 0.77 | 0.86 | |
| (3) Copntent[2)] | 0.14 | 0.014 | 0.15 | 0 | |
| Alkenyl/Epoxy[3)] | 5.5/1 | 60.7/1 | 5.1/1 | - | |
| $SiOH/(SiX^1+SiX^2)$[4)] | 1/1 | 1/1 | 1/1 | 1/1 | |
| Silicone Oil/Siloxane[5)] | 97.86/2.14 | 97.86/2.14 | 97.86/2.14 | 97.86/2.14 | |

(continued)

| | | Example 10 | Example 11 | Example 12 | Comparative Example 4 |
|---|---|---|---|---|---|
| $SiR^2/SiH$ 6) | 1/3.0 | 1/2.7 | 1/3.0 | 1/2.7 | |

Pt-TMDS complex: platinum-1,3-divinyl-1,1,3,3-tetramethylsiloxane complex

1) The content shows the content (parts by weight) of the alkenyl group-containing silicon compound (2) based on 100 parts by weight of the dual-end silanol type silicone oil.

2) The content shows the content (parts by weight) of the epoxy group-containing silicon compound (3) based on 100 parts by weight of the dual-end silanol type silicone oil.

3) The ratio shows the weight ratio (alkenyl group-containing silicon compound/epoxy group-containing silicon compound) of the alkenyl group-containing silicon compound and the epoxy group-containing silicon compound.

4) The ratio shows the ratio ($SiOH/(SiX^1+SiX^2)$) of the SiOH group content of the dual-end silanol type silicone oil and the total amount of $SiX^1$ groups of the alkenyl group containing silicon compound and $SiX^2$ groups of the epoxy group containing silicon compound.

5) The ratio shows the weight ratio (dual-end silanol type silicone oil/organohydrogensiloxane) of the dual-end silanol type silicone oil and the organohydrogensiloxane.

6) The ratio shows the ratio ($SiR^2/SiH$) of the $SiR^2$ content of the alkenyl group-containing silicon composition and the SiH content of the organohydrogensiloxane.

Using the silicone resin compositions obtained above, semi-cured materials, completely cured materials and optical semiconductor devices were prepared according to the following methods. Incidentally, also for the silicone resin composition of Comparative Example 1, a semi-cured material, a completely cured material and an optical semiconductor device were similarly prepared as reference.

Preparation of Semi-Cured Material

Each of the silicone resin compositions of Examples 10 to 12, Comparative Example 4 and Comparative Example 1 (reference) was applied on a biaxially oriented polyester film (manufactured by Mitsubishi Chemical Polyester Film Co., Ltd., 50 μm) in the same manner as in the preparation of the above-mentioned semi-cured materials. Then, the compositions of Examples 10 to 12 and Comparative Example 4 were heated at 135°C for 7 minutes, and the composition of Comparative Example 1 (reference) was allowed to stand at room temperature (25°C) for 16 hours, thereby preparing sheet-like semi-cured materials (sheets).

Preparation of Completely Cured Material

For the sheets obtained above, the sheets of Examples 10 to 12 were heated at 150°C for 16 hours, and the sheet of Comparative Example 1 (reference) was heated at 150°C for 1 hour, thereby preparing completely cured materials.

Preparation of Optical Semiconductor Device A

A substrate on which a blue LED was mounted was coated with each of the sheets in the semi-cured state of Examples 10 to 12, Comparative Example 4 and Comparative Example 1 (reference) under heat pressing conditions, followed by encapsulation processing under the same conditions as in the preparation of the above-mentioned optical semiconductor devices. The resulting device was heated at 150°C for 1 hour, thereby completely curing the resin to prepare an optical semiconductor device A.

Preparation of Optical Semiconductor Device B

A substrate on which a blue LED was mounted was coated with each of the sheets in the semi-cured state of Examples 10 to 12, Comparative Example 4 and Comparative Example 1 (reference), and a microlens mold (made of Ni, hemispherical, diameter: 10 μm, height: 5 μm) was placed thereon, followed by heating under reduced pressure at 160°C for 5 minutes using a vacuum laminator (manufactured by Nichigo-Morton Co., Ltd., Vacuum Laminator V130) to perform encapsulation processing at a pressure of 0.2 MPa. Then, the resulting device was heated at 150°C for 1 hour, thereby completely curing the resin to prepare an optical semiconductor device B.

For the resulting semi-cured materials, completely cured materials and semiconductor devices (A and B), characteristics were evaluated according to the following test example 6 (storage stability) and Test Example 7 (adhesiveness). The results thereof are shown in Table 5.

Incidentally, light transparency (the above-mentioned Test Example 2), heat resistance (the above-mentioned Test Example 3 in Examples 8 and 9), encapsulation property (the above-mentioned Test Example 4) and light resistance (the above-mentioned Test Example 5) were also evaluated similarly to the above-mentioned test methods.

Test Example 6 (Storage Stability)

When a load of 7 g/mm$^2$ was applied to the semi-cured material immediately after the preparation and after the storage at room temperature (25°C) for 24 hours by a sensor head using a digital length measuring meter (MS-5C, manufactured by Nikon Corporation), the distance the sensor head sank from a surface of the semi-cured material was measured, and the sheet hardness was determined based on the following equation:

$$\text{Sheet hardness} = [1 - (\text{the distance } (\mu m) \text{ the sensor head sank/the film thickness } (\mu m) \text{ of the semi-cured material})] \times 100$$

Then, the ratio of the resulting sheet hardnesses [(after the storage/immediately after the preparation)×100] was taken as the rate of change (%) in hardness, and storage stability was evaluated according to the following evaluation criteria:

Evaluation Criteria of Storage Stability

A: the rate of change in hardness was more than 97% or less than 103%.
B: the rate of change in hardness was from 80 to 97% or from 103 to 120%.
C: the rate of change in hardness was less than 80% or more than 120%.

Test Example 7 (Adhesiveness)

Each semi-cured material was laminated on a 42 alloy plate, followed by heating at 160°C for 5 minutes under reduced pressure, and then, pressed at a pressure of 0.2 MPa, followed by heating at 150°C for 16 hours to prepare a cured material. For the resulting cured material, peel force thereof was measured according to a 90° peel test. The higher peel force shows the more excellent adhesiveness.

Table 5

| | | | Example 10 | Example 11 | Example 12 | Comparative Example 4 | Comparative Example 1 (Reference) |
|---|---|---|---|---|---|---|---|
| Semi-Cured Material | Storage Stability | Hardness Immediately after Preparation | 2.7 | 7.4 | 2.9 | 3.0 | 7.1 |
| | | Hardness after Storage | 2.8 | 7.6 | 2.9 | 3.0 | 19 |
| | | Rate of Change in Hardness (%) | B | A | A | A | C |
| Completely Cured Material | Light Transmittance | Light Transmittance (%) | 99 | 99 | 99 | 99 | 99 |
| | Heat Resistance | Appearance | A | A | A | A | A |
| | | Residual Rate (%) | 99 | 99 | 99 | 99 | 91 |
| | Adhesiveness | Peet Force ($mN/cm^2$) | 750 | 250 | 800 | 60 | 200 |
| Semiconductor Device A | Encapsulation Property | | A | A | A | A | B |
| | Light Resistance | Luminance Retention (%) | 99 | >99 | 99 | 99 | 95 |
| Semiconductor Device B | Light Resistance | Luminance Retention (%) | 99 | >99 | 99 | 99 | 95 |

As is clear from the results of Table 5 described above, it is known that the resin compositions of Examples can form the semi-cured state, and are excellent in all of light transparency, heat resistance, light resistance and adhesiveness, compared to the compositions of Comparative Examples, so that they are excellent encapsulation materials. Incidentally, in Example 10, a composition having the same composition as that of Example 10 except for containing no alkenyl group-containing silicon compound (vinyltrimethoxysilane) was also prepared, but no completely cured material could be prepared.

## Claims

1. A thermosetting silicone resin composition comprising a condensation reactable substituent group-containing silicon compound and an addition reactable substituent group-containing silicon compound, wherein said composition comprises:

   (1) a dual-end silanol type silicone oil as the condensation reactable substituent group-containing silicon compound;
   (2) an alkenyl group-containing silicon compound;
   (3) an organohydrogensiloxane as the addition reactable substituent group-containing silicon compound;
   (4) tetramethylammonium hdroxide as a condensation catalyst; and
   (5) a hydrosilylation catalyst.

2. The thermosetting silicone resin composition according to claim 1, wherein the (1) dual-end silanol type silicone oil comprises a compound represented by Formula (I):

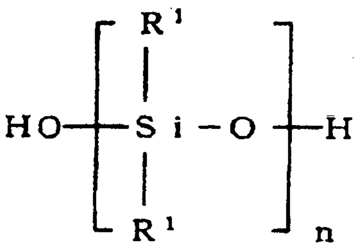

(I)

   wherein $R^1$ represents a monovalent hydrocarbon group having 1 to 20 carbon atoms or a hydrogen atom, and n is an integer of 1 or more, provided that all $R^1$ groups may be the same or different.

3. The thermosetting silicone resin composition according to claim 1 or 2, wherein the (2) alkenyl group-containing silicon compound comprises a compound represented by Formula (II):

$$R^2\text{-}Si(X^1)_3 \qquad (II)$$

   wherein $R^2$ represents a substituted or unsubstituted, straight-chain or branched alkenyl group having 2 to 20 carbon atoms, and $X^1$ represents a halogen atom, an alkoxy group, a phenoxy group or an acetoxy group, provided that three $X^1$ groups may be the same or different.

4. The thermosetting silicone resin composition according to claim 3, wherein the compound represented by Formula (II) is an alkenyl group-containing trialkoxysilane represented by Formula (II'):

$$R^2\text{-}Si(OR^3)_3 \qquad (II')$$

   wherein $R^2$ represents a substituted or unsubstituted, straight-chain or branched alkenyl group having 2 to 20 carbon atoms, and $R^3$ represents a monovalent hydrocarbon group, provided that three $R^3$ groups may be the same or different.

5. The thermosetting silicone resin composition according to any one of claims 1 to 4, wherein the (3) organohydrogensiloxane comprises at least one selected from the group consisting of a compound represented by Formula (III):

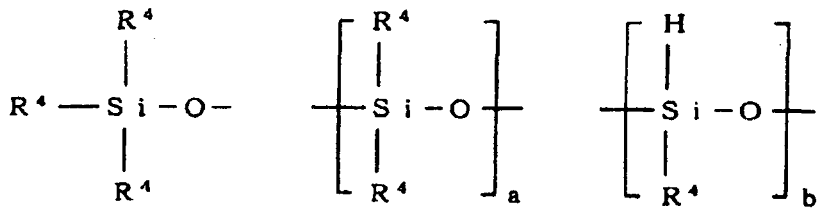

(III)

A B C

wherein A, B and C are constituent units, A represents an end unit, B and C each represents a repeating unit, $R^4$ represents a monovalent hydrocarbon group having 1 to 20 carbon atoms, a represents an integer of 0 or 1 or more, and b represents an integer of 2 or more, provided that all $R^4$ groups may be the same or different; and a compound represented by Formula (IV):

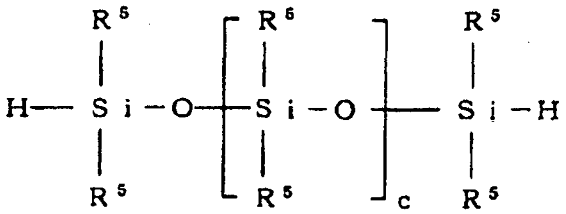

(IV)

wherein $R^5$ represents a monovalent hydrocarbon groups, and c represents an integer of 0 or 1 or more, provided that all $R^5$ groups may be the same or different.

**6.** The thermosetting silicone resin composition according to any one of claims 1 to 5, wherein the (5) hydrosilylation catalyst comprises a platinum-1,3-divinyl-1,1,33-tetramethyldisiloxane complex.

**7.** The thermosetting silicone resin composition according to any one of claims 1 to 6, further comprising an epoxy group-containing silicon compound.

**8.** The thermosetting silicone resin composition according to claim 7, wherein the epoxy group-containing silicon compound comprises a compound represented by Formula (V):

$$R^6\text{-}Si(X^2)_3 \qquad (V)$$

wherein $R^6$ represents an epoxy structure-containing substituent group, and $X^2$ represents a halogen atom, an alkoxy group, a phenoxy group or an acetoxy group, provided that three $X^2$ groups may be the same or different.

**9.** A silicone resin obtained by a condensation reaction of the thermosetting silicone resin composition according to any one of claims 1 to 8.

**10.** A silicone resin sheet obtained by forming the silicone resin according to claim 9 into a sheet in a semi-cured state by performing a condensation reaction.

**11.** The silicone resin sheet according to claim 10, having a tensile elastic modulus at 25°C of 1,000 to 1,000,000 Pa.

**12.** A method for producing a silicone resin in a semi-cured state, said method comprising a step of heating the thermosetting silicone resin composition of any one of claims 1 to 8 at 40 to 120°C.

**13.** A silicone resin cured material obtained by completely curing the silicone resin sheet according to claims 10 or 11.

**14.** An optical semiconductor element encapsulation material comprising the silicone resin sheet according to claims 10 or 11.

**15.** An optical semiconductor device obtained by encapsulating an optical semiconductor element by using the optical semiconductor element encapsulation material according to claim 14.

**16.** A microlens array obtained by molding the silicone resin according to claim 9.

**Patentansprüche**

**1.** Wärmehärtbare Siliconharzzusammensetzung, umfassend eine Siliciumverbindung, die eine zu einer Kondensationsreaktion fähige Substituentengruppe enthält, und eine Siliciumverbindung, die eine zu einer Additionsreaktion fähige Substituentengruppe enthält, wobei die Zusammensetzung umfasst:

(1) ein Siliconöl mit zwei Silanol-Endgruppen (dual-end silanol type silicone oil) als die Siliciumverbindung, die eine zu einer Kondensationsreaktion fähige Substituentengruppe enthält;
(2) eine Siliciumverbindung, die eine Alkenylgruppe enthält;
(3) ein Organohydrogensiloxan als die Siliciumverbindung, die eine zu einer Additionsreaktion fähige Substituentengruppe enthält;
(4) Tetramethylammoniumhydroxid als einen Kondensationskatalysator; und
(5) einen Hydrosilylierungskatalysator.

**2.** Wärmehärtbare Siliconharzzusammensetzung nach Anspruch 1, wobei das (1) Siliconöl mit zwei Silanol-Endgruppen eine Verbindung umfasst, die durch Formel (I) wiedergegeben ist:

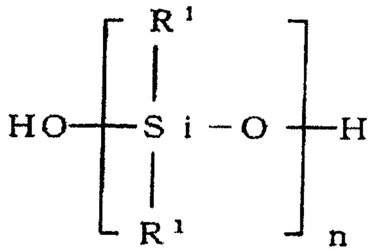

(I)

wobei $R^1$ eine einwertige Kohlenwasserstoffgruppe mit 1 bis 20 Kohlenstoffatomen oder ein Wasserstoffatom bedeutet und n eine ganze Zahl von 1 oder mehr ist, vorausgesetzt, dass alle $R^1$-Gruppen gleich oder verschieden sein können.

**3.** Wärmehärtbare Siliconharzzusammensetzung nach Anspruch 1 oder 2, wobei die (2) Siliciumverbindung, die eine Alkenylgruppe enthält, eine Verbindung umfasst, die durch Formel (II) wiedergegeben ist:

$$R^2\text{-}Si(X^1)_3 \qquad (II)$$

wobei $R^2$ eine substituierte oder unsubstituierte, geradkettige oder verzweigte Alkenylgruppe mit 2 bis 20 Kohlenstoffatomen bedeutet und $X^1$ ein Halogenatom, eine Alkoxygruppe, eine Phenoxygruppe oder eine Acetoxygruppe bedeutet, vorausgesetzt, dass drei $X^1$-Gruppen gleich oder verschieden sein können.

**4.** Wärmehärtbare Siliconharzzusammensetzung nach Anspruch 3, wobei die durch Formel (II) wiedergegebene Verbindung ein Trialkoxysilan ist, das eine Alkenylgruppe enthält und durch Formel (II') wiedergegeben ist:

$$R^2\text{-}Si(OR^3)_3 \qquad (II')$$

wobei $R^2$ eine substituierte oder unsubstituierte, geradkettige oder verzweigte Alkenylgruppe mit 2 bis 20 Kohlenstoffatomen bedeutet und $R^3$ eine einwertige Kohlenwasserstoffgruppe bedeutet, vorausgesetzt, dass drei $R^3$-Gruppen gleich oder verschieden sein können.

**5.** Wärmehärtbare Siliconharzzusammensetzung nach einem der Ansprüche 1 bis 4, wobei das (3) Organohydrogensiloxan wenigstens eines umfasst, ausgewählt aus der Gruppe bestehend aus einer Verbindung, die durch Formel (III) wiedergegeben ist:

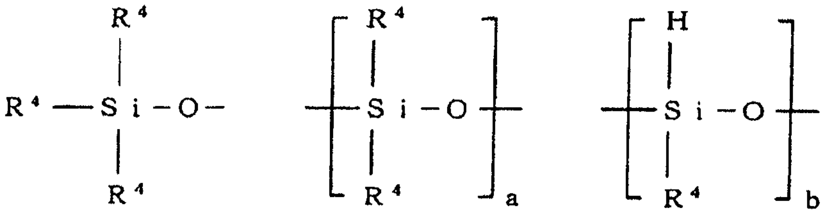

(III)

A B C

wobei A, B und C Baueinheiten sind, wobei A eine Endeinheit bedeutet und B und C jeweils eine Wiederholungseinheit bedeutet, $R^4$ eine einwertige Kohlenwasserstoffgruppe mit 1 bis 20 Kohlenstoffatomen bedeutet, a eine ganze Zahl von 0 oder 1 oder mehr bedeutet und b eine ganze Zahl von 2 oder mehr bedeutet, vorausgesetzt, dass alle $R^4$-Gruppen gleich oder verschieden sein können; und einer Verbindung, die durch Formel (IV) wiedergegeben ist:

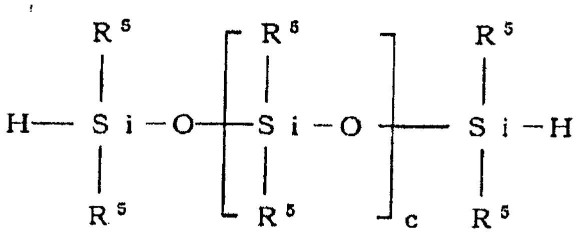

(IV)

wobei $R^5$ eine einwertige Kohlenwasserstoffgruppe beduetet und c eine ganze Zahl von 0 oder 1 oder mehr bedeutet, vorausgesetzt, dass alle $R^5$-Gruppen gleich oder verschieden sein können.

**6.** Wärmehärtbare Siliconharzzusammensetzung nach einem der Ansprüche 1 bis 5, wobei der (5) Hydrosilylierungskatalysator einen Platin-1,3-divinyl-1,1,3,3-tetramethyldisiloxankomplex umfasst.

**7.** Wärmehärtbare Siliconharzzusammensetzung nach einem der Ansprüche 1 bis 6, außerdem umfassend eine Siliciumverbindung, die eine Epoxygruppe enthält.

**8.** Wärmehärtbare Siliconharzzusammensetzung nach Anspruch 7, wobei die Siliciumverbindung, die eine Epoxygruppe enthält, eine Verbindung umfasst, die durch Formel (V) wiedergegeben ist:

$$R^6\text{-}Si(X^2)_3 \qquad (V)$$

wobei $R^6$ eine Epoxystruktur-enthaltende Substituentengruppe bedeutet und $X^2$ ein Halogenatom, eine Alkoxygruppe, eine Phenoxygruppe oder eine Acetoxygruppe bedeutet, vorausgesetzt, dass drei $X^2$-Gruppen gleich oder verschieden sein können.

**9.** Siliconharz erhalten durch eine Kondensationsreaktion der wärmehärtbaren Siliconharzzusammensetzung nach einem der Ansprüche 1 bis 8.

**10.** Siliconharzfolie erhalten durch Formen des Siliconharzes nach Anspruch 9 zu einer Folie in einem halbgehärteten Zustand durch Ausführen einer Kondensationsreaktion.

**11.** Siliconharzfolie nach Anspruch 10 mit einem Zug-Elastizitätsmodul bei 25°C von 1000 bis 1000000 Pa.

**12.** Verfahren zum Herstellen eines Siliconharzes in einem halbgehärteten Zustand, wobei das Verfahren einen Schritt des Erwärmens der wärmehärtbaren Siliconharzzusammensetzung nach einem der Ansprüche 1 bis 8 auf 40 bis 120°C umfasst.

**13.** Gehärtetes Siliconharzmaterial, erhalten durch vollständiges Härten der Siliconharzfolie nach den Ansprüchen 10 oder 11.

**14.** Material zur Einkapselung eines optischen Halbleiterelements, umfassend die Siliconharzfolie nach den Ansprüchen 10 oder 11.

**15.** Optische Halbleitervorrichtung erhalten durch Einkapseln eines optischen Halbleiterelements unter Verwendung des Materials zur Einkapselung eines optischen Halbleiterelements nach Anspruch 14.

**16.** Mikrolinsenarray erhalten durch Formen des Siliconharzes nach Anspruch 9.

## Revendications

**1.** Composition de résine de silicone thermodurcissable comprenant un composé de silicium contenant un groupe substituant apte à réagir par condensation et un composé de silicium contenant un groupe substituant apte à réagir par addition, ladite composition comprenant :

(1) une huile de silicone de type à double extrémité silanol en tant que composé de silicium contenant un groupe substituant apte à réagir par condensation ;
(2) un composé de silicium contenant un groupe alcényle ;
(3) un organohydrogénosiloxane en tant que composé de silicium contenant un groupe substituant apte à réagir par addition ;
(4) de l'hydroxyde de tétraméthylammonium en tant que catalyseur de condensation ; et
(5) un catalyseur d'hydrosilylation.

**2.** Composition de résine de silicone thermodurcissable selon la revendication 1, dans laquelle la (1) huile de silicone de type à double extrémité silanol comprend un composé représenté par la formule (I) :

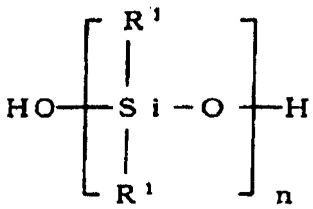

(I)

où $R^1$ représente un groupe hydrocarboné monovalent ayant 1 à 20 atomes de carbone ou un atome d'hydrogène, et n est un entier égal à 1 ou plus, sous réserve que tous les groupes $R^1$ puissent être identiques ou différents.

**3.** Composition de résine de silicone thermodurcissable selon la revendication 1 ou 2, dans laquelle le (2) composé de silicium contenant un groupe alcényle comprend un composé représenté par la formule (II) :

$R^2$-Si($X^1$)$_3$ (II)

où $R^2$ représente un groupe alcényle substitué ou non substitué, linéaire ou ramifié, ayant 2 à 20 atomes de carbone, et $X^1$ représente un atome d'halogène, un groupe alcoxy, un groupe phénoxy ou un groupe acétoxy, sous réserve que trois groupes $X^1$ puissent être identiques ou différents.

**4.** Composition de résine de silicone thermodurcissable selon la revendication 3, dans laquelle le composé représenté par la formule (II) est un trialcoxysilane contenant un groupe alcényle représenté par la formule (II') :

$R^2$-Si(O$R^3$)$_3$ (II')

où $R^2$ représente un groupe alcényle substitué ou non substitué, linéaire ou ramifié, ayant 2 à 20 atomes de carbone, et $R^3$ représente un groupe hydrocarboné monovalent, sous réserve que trois groupes $R^3$ puissent être identiques ou différents.

**5.** Composition de résine de silicone thermodurcissable selon l'une quelconque des revendications 1 à 4, dans laquelle le (3) organohydrogénosiloxane comprend au moins un composé choisi dans le groupe constitué par un composé

représenté par la formule (III) :

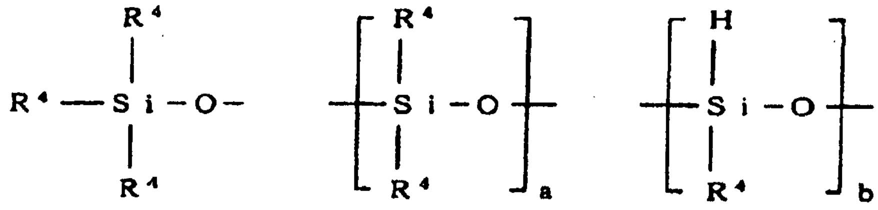

(III)

A B C

où A, B et C sont des motifs constitutifs, A représente un motif terminal, B et C représentent chacun un motif répétitif, $R^4$ représente un groupe hydrocarboné monovalent ayant 1 à 20 atomes de carbone, a représente un entier égal à 0 ou 1 ou plus, et b représente un entier égal à 2 ou plus, sous réserve que tous les groupes $R^4$ puissent être identiques ou différents ; et un composé représenté par la formule (IV) :

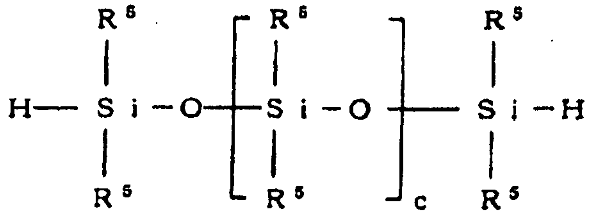

(IV)

où $R^5$ représente un groupe hydrocarboné monovalent, et c représente un entier égal à 0 ou 1 ou plus, sous réserve que tous les groupes $R^5$ puissent être identiques ou différents.

**6.** Composition de résine de silicone thermodurcissable selon l'une quelconque des revendications 1 à 5, dans laquelle le (5) catalyseur d'hydrosilylation comprend un complexe de platine-1,3-divinyl-1,1,3,3-tétraméthyldisiloxane.

**7.** Composition de résine de silicone thermodurcissable selon l'une quelconque des revendications 1 à 6, comprenant en outre un composé de silicium contenant un groupe époxy.

**8.** Composition de résine de silicone thermodurcissable selon la revendication 7, dans laquelle le composé de silicium contenant un groupe époxy comprend un composé représenté par la formule (V) :

$R^6$-Si$(X^2)_3$ (V)

où $R^6$ représente un groupe substituant contenant une structure époxy, et $X^2$ représente un atome d'halogène, un groupe alcoxy, un groupe phénoxy ou un groupe acétoxy, sous réserve que trois groupes $X^2$ puissent être identiques ou différents.

**9.** Résine de silicone obtenue par une réaction de condensation de la composition de résine de silicone thermodurcissable selon l'une quelconque des revendications 1 à 8.

**10.** Feuille de résine de silicone obtenue par façonnage de la résine de silicone selon la revendication 9 en feuille dans un état semi-durci par mise en oeuvre d'une réaction de condensation.

**11.** Feuille de résine de silicone selon la revendication 10, ayant un module d'élasticité en traction à 25 °C de 1000 à 1 000 000 Pa.

**12.** Procédé de production d'une résine de silicone dans un état semi-durci, ledit procédé comprenant une étape de chauffage de la composition de résine de silicone thermodurcissable de l'une quelconque des revendications 1 à 8 entre 40 et 120 °C.

13. Matière durcie en résine de silicone, obtenue par durcissement complet de la feuille de résine de silicone selon les revendications 10 ou 11.

14. Matière d'encapsulation d'élément semi-conducteur optique, comprenant la feuille de résine de silicone selon les revendications 10 ou 11.

15. Dispositif à semi-conducteur optique obtenu par encapsulation d'un élément semi-conducteur optique au moyen de la matière d'encapsulation d'élément semi-conducteur optique selon la revendication 14.

16. Réseau de microlentilles obtenu par moulage de la résine de silicone selon la revendication 9.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000198930 A
- JP 2004186168 A
- JP 2008150437 A
- JP 6118254 A
- EP 0273706 A
- US 4558109 A
- EP 0664328 A
- EP 0841385 A